# EUROPEAN PATENT APPLICATION

(11) **EP 4 686 368 A1**
(43) Date of publication of application: **28.01.2026**
(21) Application number: 24190855.7
(22) Date of filing: 25.07.2024
(51) Int. Cl.: H10K 85/60, C09K 5/06, F24H 7/00, F28D 20/02

(54) **A MOLECULAR SOLAR THERMAL SYSTEM (MOST) FOR LONG-TERM STORAGE OF SOLAR ENERGY**

(71) Applicant: Johannes Gutenberg-Universität Mainz, 55122 Mainz (DE)
(72) Inventor: WAHL, Johannes Markus, 55122 Mainz (DE); SANDVOß, Alexander, 55118 Mainz (DE); MAAG, Henning, 55118 Mainz (DE)
(74) Representative: Reitstötter Kinzebach

(57) **Abstract**

The present invention relates to a molecular solar thermal system (MOST) based on a pair of isomers, comprising in its low energy ground stage primarily a first low-energy isomer which is excitable by solar light to form a metastable high-energy isomer and in its high energy state primarily a second metastable high energy photoisomer generated via photochemical conversion from the solar light excitable first isomer. Said MOST system is characterized by high photo isomerization yields due to the light driven out-of-equilibrium isomerization of the first isomer and is further characterized by a superior thermal stability of the second high energy photo isomer. This allows a long-term storage of collected solar light energy without occurrence of spontaneous unwanted back-isomerization. By applying a particular class of, optionally immobilized, strong basic catalysts, the stored solar energy is released in a controlled manner in a catalytic thermalback reaction to yield the low energy first isomer. This offers the possibility of establishing a cyclic process for repeatedly converting solar light energy into thermal energy. The present invention also provides methods of storing solar thermal energy, methods of releasing stored solar thermal energy, methods of reversibly storing solar thermal energy as well as particular solar thermal energy storage devices comprising the use of the above mentioned MOST pair of photoisomers. The present invention also relates to the use of such compounds for the reversible storing of solar energy. Further aspects of the present invention relate to a solar thermal energy capture device, a combined device for capturing solar thermal energy and solar photoelectric energy, as well as a device for operating a reversible MOST system of the present invention. In addition, the present invention relates to particular novel low and high energy photoisomers applicable in a MOST system of the invention.

## Description

### FIELD OF THE INVENTION

The present invention relates to a molecular solar thermal system (MOST) based on a pair of isomers, comprising in its low energy ground stage primarily a first low-energy isomer which is excitable by solar light to form a metastable high-energy isomer and in its high energy state primarily a second metastable high energy photoisomer generated via photochemical conversion from the solar light excitable first isomer. Said MOST system is characterized by high photo isomerization yields due to the light driven out-of-equilibrium isomerization of the first isomer and is further characterized by a superior thermal stability of the second high energy photo isomer. This allows a long-term storage of collected solar light energy without occurrence of spontaneous unwanted back-isomerization. By applying a particular class of, in particular immobilized, strong basic catalysts, the stored solar energy is released in a controlled manner in a catalytic thermal back reaction to yield the low energy first isomer. This offers the possibility of establishing a cyclic process for repeatedly converting solar light energy into thermal energy. The present invention also provides methods of storing solar thermal energy, methods of releasing stored solar thermal energy, methods of reversibly storing solar thermal energy as well as particular solar thermal energy storage devices comprising the use of the above mentioned MOST pair of photoisomers. The present invention also relates to the use of such compounds for the reversible storing of solar energy. Further aspects of the present invention relate to a solar thermal energy capture device, a combined device for capturing solar thermal energy and solar photoelectric energy, as well as a device for operating a reversible MOST system of the present invention. In addition, the present invention relates to particular novel low and high energy photoisomers applicable in a MOST system of the invention.

### BACKGROUND OF THE INVENTION

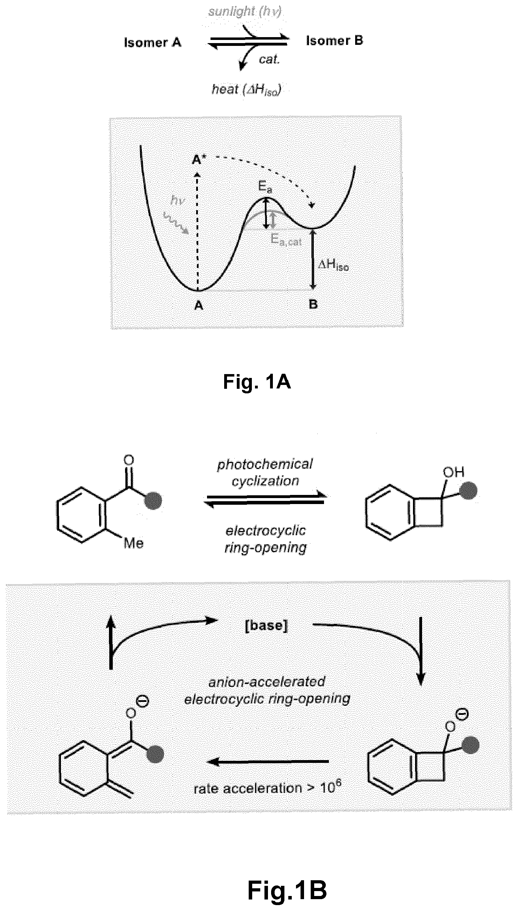

The utilization of solar energy is one of the key scientific challenges of the 21^{st} century, offering significant potential for mitigating climate change (N. S. Lewis, et al., Proceedings of the National Academy of Sciences 103, 15729-15735 (2006). doi:10.1073/pnas.0603395103). In this regard, light-driven out-of-equilibrium isomerization offers an attractive pathway for harnessing photon energy and embedding it within chemical bonds (M. Kathan, et al., Chemical Society reviews 46, 5536-5550 (2017). doi:10.1039/C7CS00112F; H. Wang, et al. Nat. Rev. Chem. 6, 745-755 (2022). doi:10.1038/s41570-022-00421-6.). If a thermal back reaction can be triggered after photochemical isomerization, this tandem process offers a sustainable approach to heat generation, which currently accounts for more than 90% of the world's energy consumption (**Fig. 1A**) (I. Gur, K. Sawyer, R. Prasher, Searching for a Better Thermal Battery. Science 335, 1454-1455 (2012). doi:10.1126/science.1218761).

In contrast to solar thermal collectors, heat generation by molecular solar thermal (MOST) systems offers a temporal separation between the time when the energy is generated and when it is released This can, e.g., be controlled by the introduction of a suitable catalyst initiating back-isomerization. However, identifying compounds for MOST application is challenging due to the intricate interplay between the photochemical and thermal isomerization processes (T. J. Kucharski, et alEnergy & Environmental Science 4, 4449-4472 (2011). doi:10.1039/C1EE01861B; Z. Wang et al., Joule 5, 3116-3136 (2021). doi:10.1016/j.joule.2021.11.001; J. Usuba, et al., Trends Chem. 5, 577-580 (2023). doi:10.1016/j.trechm.2022.12.010; A. Giménez-Gómez, et al., React. Chem. Eng. (2024). doi:10.1039/D4RE00131A)

In this context, a number of privileged compounds have been proposed, which include
- norbornadiene ⇄ quadricyclane (A. D. Dubonosov, et al Russian Chemical Reviews. 71, 917-927 (2002), doi:10.1070/RC2002v071n11ABEH000745),
- E-azobenzene ⇄ Z-azobenzene (B. Zhang, et al., Nano-Micro Letters. 14, 138 (2022). doi:10.1007/s40820-022-00876-8), and
- dihydroazulen ⇄ vinylheptafulven (J. Daub, et al., Angew. Chem. Int. Ed. 23, 960-961 (1984). doi: 10.1002/anie. 198409601).

Current research concentrates on identifying new isomer couples (R. Boese, et al., J J. Am. Chem. Soc. 119, 6757-6773 (1997). doi:10.1021/ja9707062.;Y. Kanai, et al., Angew. Chem. Int. Ed. 49, 8926-8929 (2010). doi:10.1002/anie.201002994; K. Edel, et al., Angew. Chem. Int. Ed. 57, 5296-5300 (2018). doi:10.1002/anie.201712683; Q. Qiu, et al., J. Am. Chem. Soc. 144, 12627-12631 (2022). doi:10.1021/jacs.2c05384; and R. C. Richter, et al.,Angew. Chem. Int. Ed. 63, e202405818 (2024). doi:10.1002/anie.202405818.) and on improving the photophysical properties of the established systems (M. Quant, et al., Chem. Eur. J. 22, 13265-13274 (2016). doi:10.1002/chem.201602530; J. Orrego-Hernández, et al., Acc. Chem. Res. 53, 1478-1487 (2020). doi:10.1021/acs.accounts.0c00235; A. E. Hillers-Bendtsen, et al., Angew. Chem. Int. Ed. 62, e202309543 (2023). doi:10.1002/anie.202309543).

Important metrics for MOST optimization are high isomerization rates (>95%), significant back-isomerization energies (ΔHᵢₛₒ), and a good overlap with the solar spectrum (λ = 300-800 nm). A major challenge remains the improvement of the thermal stability of the photoisomer, which is a crucial factor for safe and long-term energy storage. This endeavor is further frustrated by the notion that higher thermal stability often correlates with a decrease in stored energy (K. Börjesson, et al., ACS Sustainable Chem. Eng. 1, 585-590 (2013). doi:10.1021/sc300107z; and M. Cacciarini, et alChem. Eur. J. 21, 7454-7461 (2015). doi:10.1002/chem.201500100). The identification of catalysts that trigger heat release at stable photoisomers adds another hurdle for devising a reliable system.

The problem to be solved by the present invention has to be seen in the development of an improved MOST system, which is characterized by at least one of the following improvements: high isomerization rates, high back-isomerization energies, high thermal stability of the high-energy photoisomer, and a rate accelerating catalyst triggering the thermal back reaction, which may be quantitatively separated from the constituents of the MOST couple, and which is reusable.

### SUMMARY OF THE INVENTION

The above problem was, surprisingly, solved by the present inventors, by identifying well-balanced isomer pairs that meet the stringent photochemical and physicochemical prerequisites for a MOST application. Moreover, the problem was solved by providing a back-isomerization reaction based on an anion-accelerated ring opening reaction, employing a simple organic base as catalyst, which triggers efficient heat release at ambient temperatures.

### BRIEF DESCRIPTION OF THE FIGURES

**Figure 1****:** Illustrates schematically the storing of solar energy with molecular isomers. **(A)** Schematic representation of a MOST system. **(B)** Design of an energy storage couple based on the photocyclization and thermal reversion of *ortho*-methylacetophenones.
**Figure 2****:** Development of an efficient photoisomerization of *ortho*-methylacetophenones. **(A)** Mechanistic considerations and current limitations for the photocyclization of *ortho-*methylacetophenone **1a. (B)** Reaction optimization addressing the acetyl liability. **(C)** Mechanistic investigations uncovering key factors for cyclization efficiency. **(D)** Assessing the reaction robustness for MOST application.
**Figure 3****:** Establishing back-isomerization through catalysis. **(A)** Thermal ring-opening based on 4-π electrocyclic ring opening. **(B)** Identification of catalysts based on anionic rateacceleration. **(C)** Calorimetric analysis of the ring opening event.
**Figure 4****:** Establishing cyclability of the MOST system by the application of sunlight irradiation and an immobilized base
**Figure 5****:** Visualization of the relative rates of the photo cyclization. The size of the bubbles indicates the difference between conversion and yield of product, where bigger bubbles corresponded to a large amount of side reactions.
**Figure 6****:** Schematic drawing of a device for reversibly storing and setting free of solar thermal energy in a closed circular system.
**Figure 7****:** Schematic drawing of a combined collector module for collecting solar thermal and photoelectric energy.

### DETAILED DESCRIPTION OF THE INVENTION

### A. ABBREVIATIONS

| | |
|---|---|
| MOST | molecular solar thermal system |
| pKa | negative base-10 logarithm of the acid dissociation constant (Kₐ) |
| ΔHᵢₛₒ | back-isomerization energy (also abbreviated as ΔH_{storage}) |

### B. DEFINITIONS

### B.1 General Definitions

Unless otherwise defined herein, scientific and technical terms used in connection with the present invention shall have the meanings that are commonly understood by those of ordinary skill in the art. The meaning and scope of the terms should be clear, however, in the event of any latent ambiguity, definitions provided herein take precedent over any dictionary or extrinsic definition. Further, unless otherwise required by context, singular terms shall include pluralities and plural terms shall include the singular.

The terms "purified", "substantially purified," and "isolated" as used herein refer to the state of being free of other, dissimilar compounds with which a compound of the invention is normally associated in its natural state, so that the "purified", "substantially purified," and "isolated" subject comprises at least 0.5%, 1%, 5%, 10%, or 20%, or at least 50% or 75% of the mass, by weight, of a given sample. In one embodiment, these terms refer to the compound of the invention comprising at least 95, 96, 97, 98, 99 or 100%, of the mass, by weight, of a given sample. As used herein, the terms "purified", "substantially purified," and "isolated" when referring to a nucleic acid or protein, also refers to a state of purification or concentration different than that which occurs naturally, for example in a prokaryotic or eukaryotic environment, like, for example in a bacterial or fungal cell, or in the mammalian organism, especially human body. Any degree of purification or concentration greater than that which occurs naturally, including (1) the purification from other associated structures or compounds or (2) the association with structures or compounds to which it is not normally associated in said prokaryotic or eukaryotic environment, are within the meaning of "isolated". The nucleic acid or protein or classes of nucleic acids or proteins, described herein, may be isolated, or otherwise associated with structures or compounds to which they are not normally associated in nature, according to a variety of methods and processes known to those of skill in the art.

In the context of the descriptions provided herein and of the appended claims, the use of "or" means "and/or" unless stated otherwise.

Similarly, "comprise," "comprises," "comprising", "include," "includes," and "including" are interchangeable and not intended to be limiting.

It is to be further understood that where descriptions of various embodiments use the term "comprising," those skilled in the art would understand that in some specific instances, an embodiment can be alternatively described using language "consisting essentially of" or "consisting of."

The term "about" indicates a potential variation of ± 25% of the stated value, in particular ± 15%, ±10 %, more particularly ± 5%, ± 2% or ± 1%.

The term "substantially" describes a range of values of from about 80 to 100%, such as, for example, 85-99.9%, in particular 90 to 99.9%, more particularly 95 to 99.9%, or 98 to 99.9% and especially 99 to 99.9%.

"Predominantly" or "primarily" refers to a proportion in the range of above 50%, as for example in the range of 51 to 100%, particularly in the range of 75 to 99,9%; more particularly 85 to 98,5%, like 95 to 99%.

A MOST couple according to the present invention is typically represented by at least one pair of corresponding isomers of at least one chemical compound, at least one isomeric form in a solar light excitable, low energy state, and at least one other in a high energy solar light excited state, which remains in said high energy state for a sufficient period of time to allow storage of solar energy, and, which under the action of an external stimulus, as for example a suitable catalyst, will release the stored solar energy as thermal energy, and will be reverted to the solar light excitable, low energy state.

A MOST system, according to the present invention, comprises a MOST couple as defined above, dissolved in a liquid organic solvent in which the light induced conversion between said at least two isomers takes place, and which is also suited to maintain the at least one high energy isomer in a dissolved state during the entire time span of energy storage and subsequent reconversion to the corresponding low energy isomer.

If the present disclosure refers to features, parameters and ranges thereof of different degree of preference (including general, not explicitly preferred features, parameters and ranges thereof) then, unless otherwise stated, any combination of two or more of such features, parameters and ranges thereof, irrespective of their respective degree of preference, is encompassed by the disclosure of the present description.

### B.2 Chemical definitions

The term "lower alkyl" as used herein and in the alkyl moieties of "lower alkoxy" and the like refers to saturated straight-chain (i.e. linear) or branched hydrocarbon radicals having 1 to 2 ("C₁-C₂-alkyl"), 1 to 3 ("C₁-C₃-alkyl"), 1 to 4 ("C₁-C₄-alkyl") or 1 to 6 ("C₁-C₆-alkyl"). C₁-C₂-Alkyl is methyl or ethyl. C₁-C₃-Alkyl is additionally propyl and isopropyl. C₁-C₄-Alkyl is additionally butyl, 1-methylpropyl (sec-butyl), 2-methylpropyl (isobutyl) or 1,1-dimethylethyl (tert-butyl). C₁-C₆-Alkyl is additionally also, for example, pentyl, 1-methylbutyl, 2-methylbutyl, 3-methylbutyl, 2,2-dimethylpropyl, 1-ethylpropyl, 1,1-dimethylpropyl, 1,2-dimethylpropyl, hexyl, 1-methylpentyl, 2-methylpentyl, 3-methylpentyl, 4-methylpentyl, 1,1-dimethylbutyl, 1,2-dimethylbutyl, 1,3-dimethylbutyl, 2,2-dimethylbutyl, 2,3-dimethylbutyl, 3,3-dimethylbutyl, 1-ethylbutyl, 2-ethylbutyl, 1,1,2-trimethylpropyl, 1,2,2-trimethylpropyl, 1-ethyl-1-methylpropyl, or 1-ethyl-2-methylpropyl.

The term "haloalkyl" as used herein, which may also be expressed as "alkyl which is partially or fully halogenated", refers to straight-chain or branched alkyl groups having 1 to 2 ("C₁-C₂-haloalkyl"), 1 to 3 ("C₁-C₃-haloalkyl"), 1 to 4 ("C₁-C₄-haloalkyl") or 1 to 6 ("C₁-C₆-haloalkyl") carbon atoms (as mentioned above), where some or all of the hydrogen atoms in these groups are replaced by fluorine atoms. Examples for C₁-C₂-haloalkyl (indeed for fluorinated C₁-C₂-alkyl) are fluoromethyl, difluoromethyl, trifluoromethyl, 1-fluoroethyl, 2-fluoroethyl, 2,2-difluoroethyl, 2,2,2-trifluoroethyl, or pentafluoroethyl. Examples for C₁-C₃-haloalkyl (indeed for fluorinated C₁-C₃-alkyl) are, in addition to those mentioned for C₁-C₂-haloalkyl, 1-fluoropropyl, 2-fluoropropyl, (R)-2-fluoropropyl, (S)-2-fluoropropyl, 3-fluoropropyl, 1,1-difluoropropyl, 2,2-difluoropropyl, 1,2-difluoropropyl, 2,3-difluoropropyl, 3,3-difluoropropyl, 2,2,3-trifluoropropyl, 3,3,3-trifluoropropyl, 2,2,3,3-tetrafluoropropyl, 2,2,3,3,3-pentafluoropropyl, heptafluoropropyl, 1,1,1-trifluoroprop-2-yl, 2-fluoro-1-methylethyl, (R)-2-fluoro-1-methylethyl, (S)-2-fluoro-1-methylethyl, 2,2-difluoro-1-methylethyl, (R)-2,2-difluoro-1-methylethyl, (S)-2,2-difluoro-1-methylethyl, 2,2,2-trifluoro-1-methylethyl, (R)-2,2,2-trifluoro-1-methylethyl, (S)-2,2,2-trifluoro-1-methylethyl, 2-fluoro-1-(fluoromethyl)ethyl, 1-(difluoromethyl)-2,2-difluoroethyl, 1-(trifluoromethyl)-2,2,2-trifluoroethyl, 1-(trifluoromethyl)-1,2,2,2-tetrafluoroethyl and the like. Examples for C₁-C₄-haloalkyl are, in addition to those mentioned for C₁-C₃-haloalkyl, 2-fluorobutyl, (R)-2-fluorobutyl, (S)-2-fluorobutyl, 3-fluorobutyl, (R)-3-fluorobutyl, (S)-3-fluorobutyl, 4-fluorobutyl, 2,2-difluorobutyl, 3,3-difluorobutyl, 4,4-difluorobutyl, 4,4,4-trifluorobutyl, 3,3,4,4-tetrafluorobutyl, 3,4,4,4-tetrafluorobutyl, 2,2,4,4,4-pentafluorobutyl, 3,3,4,4,4-pentafluorobutyl, 2,2,3,4,4,4-hexafluorobutyl, 1-methyl-2,2-3,3-tetrafluoropropyl and the like.

The term "cycloalkyl" unless otherwise indicated refers to monocyclic saturated carbocyclic radicals having 5 to 8 carbon ring members ("Cs-Cs-cycloalkyl"). Examples are cyclopentyl, cyclohexyl, cycloheptyl and cyclooctyl.

The term "hetero-cycloalkyl" unless otherwise indicated refers to monocyclic saturated analogues of the above-identified cycloalkyl residues, additionally contain in its carbocyclic radicals having 5 to 8 carbon ring members 1 or more, as for example 1, 2 or 3 ring heteroatoms, selected from N, O and S

The term "heterocyclic" refers to a monocyclic or polycyclic, like di- or tri-cyclic saturated, or mono- or polyunsaturated non-aromatic or aromatic ring moiety, containing 5 to 14, in particular 5 to 10, like 5 or 6 ring atoms and including 1 to 5, in particular 1, 2 or 3 identical or different ring heteroatom, selected from N, O and S.

The term "aryl" relates to monovalent mono- or polycyclic aromatic moieties, in particular having 6 to 14 ring carbon atoms, in particular, phenyl, o-, m- or p-toluyl, o-, m- or p-xylyl, byphenyl, fluorenyl, naphthenyl, anthraceneyl and phenanthrenyl.

The term "heteroaryl" refers to an aromatic, monocyclic or polycyclic, like di- or tri-cyclic aromatic ring moiety, containing 5 to 14, in particular 5 to 10 ring atoms, including 1 to 5, in particular 1, 2 or 3 identical or different ring heteroatom selected from N, O and S. Examples for 5- or 6-membered monocyclic heteroaromatic rings or bicyclic heteroaromatic rings containing 1, 2, 3 or 4 heteroatoms selected from the group consisting of N, O and S as ring members are, 2-furyl, 3-furyl, 2-thienyl, 3-thienyl, 1-pyrrolyl, 2-pyrrolyl, 3-pyrrolyl, 1-pyrazolyl, 3-pyrazolyl, 4-pyrazolyl, 5-pyrazolyl, 1-imidazolyl, 2-imidazolyl, 4-imidazolyl, 5-imidazolyl, 2-oxazolyl, 4-oxazolyl, 5-oxazolyl, 3-isoxazolyl, 4-isoxazolyl, 5-isoxazolyl, 2-thiazolyl, 4-thiazolyl, 5-thiazolyl, 3-isothiazolyl, 4-isothiazolyl, 5-isothiazolyl, 1,3,4-triazol-1-yl, 1,3,4-triazol-2-yl, 1,3,4-triazol-3-yl, 1,2,3-triazol-1-yl, 1,2,3-triazol-2-yl, 1,2,3-triazol-4-yl, 1,2,5-oxadiazol-3-yl, 1,2,3-oxadiazol-4-yl, 1,2,3-oxadiazol-5-yl, 1,3,4-oxadiazol-2-yl, 1,2,5-thiadiazol-3-yl, 1,2,3-thiadiazol-4-yl, 1,2,3-thiadiazol-5-yl, 1,3,4-thiadiazol-2-yl, 2-pyridinyl, 3-pyridinyl, 4-pyridinyl, 5-pyridinyl, 3-pyridazinyl, 4-pyridazinyl, 2-pyrimidinyl, 4-pyrimidinyl, 5-pyrimidinyl, 2-pyrazinyl, 1,3,5-triazin-2-yl, 1,2,4-triazin-3-yl, 1,2,4-triazin-5-yl, 1,2,3,4-tetrazin-1-yl, 1,2,3,4-tetrazin-2-yl, 1,2,3,4-tetrazin-5-yl, quinolin-3-yl, 1*H*-pyrrolo[2,3-b]pyridine-5-yl, 1,8-naphthyridin-3-yl, 1*H*-benzo[d]imidazol-2-yl and the like.

The term "substituted heteroaryl ring" refers to mono- or poly-substituted analogues of the above-mentioned heteroaryl rings. In particular, they may be substituted by 1 or more, in particular 1, 2, 3, 4 or 5 identical or different substituents as defined herein below.

The term "substituted carbocyclic ring" refers to mono- or poly-substituted analogues of the above-mentioned aromatic or non-aromatic carbocyclic rings as defined above. In particular, they may be substituted by 1 or more, in particular 1, 2, 3, 4 or 5 identical or different substituents as defined herein below.

Unless indicated otherwise, the term "substituted" or "substituent" means that a radical is substituted with residues selected from the group of halogen, like F, Cl and Br, - C(halogen)₃, wherein halogen residues thereof are identical or different and are selected from F, Cl and Br; -C₁-C₃-alkyl, -C₁-C₃-hydroxyalkyl, -C₁-C₃-cyanoalkyl, -C₁-C₃-alkylene-C(O)O-C₁-C₄-alkyl, -C₃-C₈-cycloalkyl, -OH, -CN, -C(O)OH,- C(O)O(-C₁-C₄-alkyl), -O-C₁-C₃-alkyl or -C(O)NR^{a}R^{b}, wherein R^{a} and R^{b} are independently selected from H or -C₁-C₄-alkyl.

The term "halogen" denotes in each case fluorine, bromine, chlorine or iodine, in particular fluorine, chlorine or bromine. Halogen as a substituent on an aromatic or heteroaromatic group is particularly selected from F, Cl or Br.

The term "mono- or polycyclic aromatic ring system" (abbreviated "Ar"), is selected from monocyclic aromatic rings having 6 ring carbon atoms ("benzo groups), wherein at least 2 neighbored (ortho-positioned) carbon atoms are substituted as further defined herein below for compounds of formulae I or II, said ortho-positioned pairs of ring substituents being involved in the light-driven photo isomerization; polycyclic aromatic groups derived from condensed polycyclic groups having 10 to 32, or particularly 10 to 16 ring carbon atoms, in particular naphthalene, anthracene, phenanthrene, or pyrene, wherein at least 2 neighbored (ortho-positioned) carbon atoms are substituted as further defined herein below for compounds of formulae I or II, said ortho-positioned pairs of ring substituents being involved in the light-driven photo isomerization; or polycyclic aromatic groups derived from a plurality of monocyclic aromatic rings and/or condensed polycyclic aromatic rings linked together either via a carbon-carbon single bond or via an alkenylene bridge providing a conjugating linkage between 2 neighboring aromatic rings of the system, wherein at least 2 neighbored (ortho-positioned) carbon atoms are substituted as further defined herein below for compounds of formulae I or II, said ortho-positioned pairs of ring substituents being involved in the light-driven photo isomerization.

A "monocyclic aromatic ring system" as used in the context of the invention comprises 6 carbon atoms: and is typically benzene, in this context also designated "benzo group".

A "condensed aromatic ring system" as used in the context of the invention comprises at least two fused aromatic rings sharing in common at least two neighbored, adjacent carbon atoms of at least two aromatic rings, and comprising 10 to 32 carbon atoms. Nonlimiting examples thereof are derived from: naphthalene (C₁₀H₈), anthracene (C₁₄H₁₀), phenanthrene (C₁₄H₁₀), pyrene (C₁₆H₁₀), chrysene (C₁₈H₁₂),benzo[a]pyrene (C₂₀H₁₂), perylene (C₂₀H₁₂), coronene (C₂₄H₄₂), fluoranthene (C₁₆H₁₀), benzo[g,h,i]perylene (C₂₂H₄₂), benz[a]anthracene (C₁₈H₁₂), indeno[1,2,3-cd]pyrene (C₂₂H₄₂), triphenylene (C₁₈H₁₂), ovalene (C₃₂H₁₄), and acenaphthylene (C₁₂H₈).

A "conjugated aromatic ring system" according to the present invention comprises at least two aromatic rings linked together either via a chemical carbon-carbon single bond or via an "alkenylene bridge" providing a conjugating linkage between 2 neighboring aromatic rings of the system, as for example -CH=CH- and -CH=CH-CH=CH-.

"Alkylene" is a linear or branched divalent alkanediyl radical. C₁-C₃-Alkylene is a linear or branched divalent alkyl radical having 1, 2 or 3 carbon atoms. C₁-C₄-Alkylene is a linear or branched divalent alkyl radical having 1, 2, 3 or 4 carbon atoms. C₁-C₆-Alkylene is a linear or branched divalent alkyl radical having 1, 2, 3, 4, 5 or 6 carbon atoms. Examples are -CH₂-, - CH₂CH₂-, -CH(CH₃)-, -CH₂CH₂CH₂-, -CH(CH₃)CH₂-, -CH₂CH(CH₃)-, -C(CH₃)₂-, - CH₂CH₂CH₂CH₂-, -CH(CH₃)CH₂CH₂-, -CH₂CH₂CH(CH₃)-, -C(CH₃) ₂CH₂-, -CH₂C(CH₃)₂-, - (CH₂)₅-, -(CH₂)₆-, -(CH₂)₇-, -(CH₂)₈-, -(CH₂)₉-, -(CH₂)₁₀- and positional isomers thereof.

"Alkenylene" refers to the mono-unsaturated analogues of the above mentioned alkylenes, having 2, 3 or 4 carbon atoms (C₂-C₄-alkenylenes) or having 2, 3, 4, 5 or 6 carbon atoms (C₂-C₆-alkenylenes). Suitable "alkenylene" bridges are for example ethenylene groups (-CH=CH-). Other examples are polyunsaturated branched or in particular linear alkenylene groups comprising at least 2 conjugated carbon/carbon double bonds. Nonlimiting examples thereof are: -CH=CH-CH=CH-, -CH=CH-CH=CH-CH=CH- or -CH=CH-CH=CH-CH=CH-CH=CH-, higher homologues as obtained by extending the hydrocarbon chain by at least one further terminal -CH=CH- group.

The above-mentioned mono- or polycyclic, condensed or conjugated aromatic ring systems ("Ar")may be further substituted. They may contain per aromatic ring element one or more, as for example for a mononuclear benzo group, 1, 2, 3 or 4, particularly 1 or 2, or most particularly 1 identical or different ring substituents R³. Said at least one substituent R³ may be present at at least one "free" carbon atom of the aromatic ring system which does not carry am member of those ortho-positioned pairs of ring substituents involved in the light-driven photo isomerization reaction of the system. Such one or more residues R³ are selected from cyano, halogen, lower alkyl, lower alkoxy, or -C(O)R¹, wherein R¹ is selected from -C (halogen)₃₋ₐHₐ, wherein a is 0, 1 or 2, in particular 0 or 1, and halogen is selected from F, Cl or Br; aryl; cyano; linear or branched lower-alkoxy, or -C(O)OR, wherein R is linear or branched lower alkyl.

An "ortho-positioned pair of ring substituents" involved in the light-driven photo isomerization reaction of the system consist of a pair of two different ring substituents attached to two neighbored ring carbon atoms. The first ring substituent is of the formula - C(O)R¹ as defined herein, and the second ring substituent placed in ortho-position to the first is of the formula -CR²R^{2a}R^{2b} , which upon photo isomerization will form, together with the carbon atoms which they are attached to, a 4-membered cyclobutene ring structure of the formula

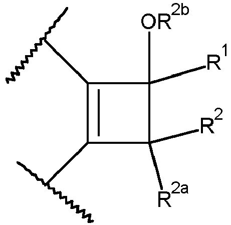

The term "mono- or polycyclic, aromatic or non-aromatic C₅ - C₁₆ residue" optionally substituted with at least one basic residue comprising at least one basic nitrogen atom, encompasses "mono- or polycyclic non-aromatic C₅ - C₁₆ residue" as well as "mono- or polycyclic, aromatic C₆ - C₁₆ residues each optionally substituted with at least one basic residue comprising at least one basic nitrogen atom.

In particular, in this respect, but also more generally a substituent "with at least one basic residue comprising at least one basic nitrogen atom" may for example be selected from a residue of the formula

-N(alkyl)₂,

-N=C(N-(alkyl)₂)₂,

wherein "alkyl" independently of each other represents a linear or branched C₁-C₄ residue,
or a residue of one of the following two formulae 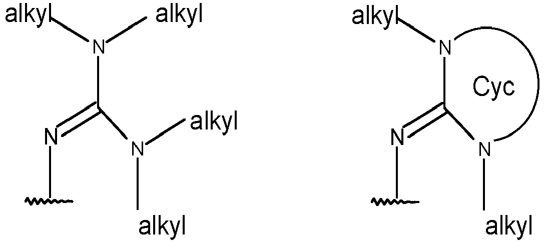 wherein
   "alkyl" independently of each other represents a linear or branched C₁-C₄ residue, and
   "Cyc" together with the nitrogen atoms, to which it is attached, forms a 5 to 7 membered heterocyclic, saturated or unsaturated ring. In particular, an alkylene or alkenylene bridge is inserted between said two nitrogen atoms in order to form said heterocyclic ring.

In this respect a "mono- or polycyclic non-aromatic C₅ - C₁₆ residue" comprises a carbocyclic ring system which may be a mono- or polycyclic, like di- or tri-cyclic, carbocyclic ring, and may be a saturated or mono- or polyunsaturated, nonaromatic ring system, like for example a monocyclic cycloalkyl or monocyclic cycloalkenyl ring system, as herein further defined. The term "cycloalkyl" in this respect refers to monocyclic saturated carbocyclic radicals having 5 to 8 carbon ring members ("Cs-Cs-cycloalkyl"). Examples are cyclopentyl, cyclohexyl, cycloheptyl and cyclooctyl. The term "cycloalkenyl" in this respect refers to monocyclic mono-or poly-unsaturated non-aromatic analogues id the above-mentioned cycloalkyl groups.

The term "mono- or polycyclic, aromatic C₆ - C₁₆ residue" refers to mono- or polycyclic, like di- or tri-cyclic, carbocyclic ring containing 6 to 16, in particular 6 to 10 carbon atoms. Examples thereof are phenyl, naphthyl, phenanthrenyl, fluorenyl and anthracenyl.

An "organic superbase" is defined as the structural combination of basic functional groups in a neutral organic compound that result in a basicity greater than the basicity of N,N,N',N'-tetramethyl-1,8-naphthalene diamine, CAS NO 20734-58-1 (commercialized under the trade name *Proton sponge* ^{®} by Sigma Aldrich and having a pKa of 18,6 as determined in acetonoitrile). In this context reference is made to Puleo et al., Cem Eur J 2021,27, 4216-4229 and textbook Superbases for Organic Synthesis: Guanidines, Amidines, Phosphazenes and Related Organocatalysts, Editor(s):Professor Tsutomu Ishikawa, First published:28 January 2009; Print ISBN:9780470518007 Copyright © 2009 John Wiley & Sons, Ltd. Such superbases may be further subdivided into currently three different classes: the amidine class, the guanidine class and the phosphazene class.

The pKa value of a base may also be described as pK_{BH+} value of the corresponding conjugated acid of said base.

Any pKa value as referred to herein, unless otherwise defined, refers to the pKa value as determined in acetonitrile.

An "immobilized or non-immobilized organic strong base" in the context of the present invention refers to a herein defined organic strong base or superbase, which is, preferably equivalently bound to conventional, particularly spherical, microbeads, for example in the range of 50 to 200 µm. The purpose of such modification is to provide the organic superbase in an immobilized form which allows to provide said superbase as a stationary phase. Said microbeads have to be provided in a state which is not soluble in the liquid carrier medium containing the isomers (A) and/or (B) of the invention in a dissolved state. This allows a controlled contact between said liquid carrier medium and the immobilized superbase, for the controlled release of the solar energy stored in isomer (B).

An "anion-accelerated electro-cyclic ring opening" is defined as a reaction where the presence of a covalently attached anion such as alkoxy speeds up the process of converting a cyclic structure into an open-chain structure through a concerted electron rearrangement mechanism.

Compounds as herein described may contain one or more asymmetric elements such as stereogenic centers, stereogenic axes and the like, e.g. asymmetric carbon atoms, so that the compounds can exist in different stereoisomeric forms. These compounds can be, for example, racemates or optically active forms. All stereoisomers, diastereomers, Z- and E-forms, in purified and mixture forms are included.

Compounds as herein described may also exist in the form of different "constitutional isomers". A "constitutional isomer" (which also may be designated as "structural isomer") of a compound is another compound whose molecule has the same number of atoms of each element, but distinct bonds between them. As for example, a particular residue or a particular group of residues may be present at different position of the same linear or circular molecular skeleton of a molecule

Accordingly, when a compound is recited by specific name or a class of compounds is recited, all these above-identified isomeric forms are intended to be included.

Therefore, unless otherwise stated, for each of the compounds as described herein, any such potential stereo- or regiosomeric form or mixture of more than one stereo- and /or regiosomeric form is within the scope of the present invention. Similarly, for each of the compounds as described herein, any such potential constitutional isomer or mixture of more than one constitutional isomer is within the scope of the present invention.

### C. PARTICULAR ASPECTS AND EMBODIMENTS

### 1. The first aspect of the present invention

According to a first embodiment of the invention a molecular solar thermal system (MOST) is provided, comprising an organic phase, which, in particular, is liquid in the temperature range where the MOST system is operated, and which contains
a) in its low-energy ground state primarily at least one solar light excitable low-energy parent photoisomer (A), which is excitable by solar light in the wavelength range of 300 to 600 nm,
b) in its excited state primarily at least one (metastable) high-energy photo isomer (B) generated by solar light, in particular in the wavelength range of 300 to 600 nm, via photochemical conversion from said at least one solar light excitable low-energy parent isomer (A),
wherein;
said at least one (metastable)( high-energy photo isomer (B) is a compound of general formula (I) 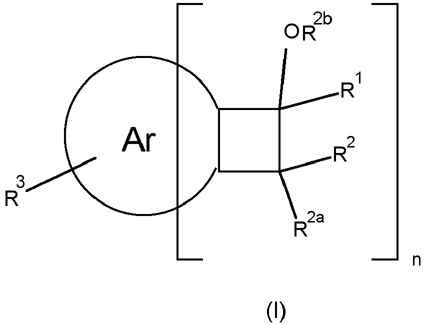 wherein,
n is an integer of 1, 2 or 3,
R¹ is selected from -C (halogen)₃₋ₐHₐ, wherein a is 0, 1 or 2, in particular 0 or 1, and halogen is selected from F, Cl or Br, in particular -CF₃; aryl; cyano; lower alkoxy, in particular methoxy; or -C(O)OR, wherein R is lower alkyl, in particular methyl;
R² and R^{2a} are identical or different and independently of each other selected from H, D, linear or branched lower alkyl or linear or branched lower alkoxy, like methyl or methoxy; most particularly R² and R^{2a} are independently selected from H or D; R^{2b} is selected from H or D;
Ar represents an aromatic mono- or polycyclic, in particular mono- or bicyclic, condensed aromatic ring system or conjugated aromatic ring system, in which ring system at least one hydrogen atom of the aromatic ring system may be further substituted by one or more identical or different ring substituents R³,
wherein
R³ is selected from cyano, halogen, , linear or branched lower alkyl, in particular methyl; linear or branched lower alkoxy, in particular methoxy; and - C(O)R¹, wherein R¹ is as defined above
or a constitutional isomer or stereoisomer of the compound of formula I;
or a mixture of at least two constitutional isomers or a mixture of at least two stereoisomers or a mixture of at least one stereoisomer and at least one constitutional isomer;
said solar light excitable low-energy parent isomer (A) is a compound excitable by solar light, in particular in the wavelength range of 300 to 600 nm, and having the general formula (II) 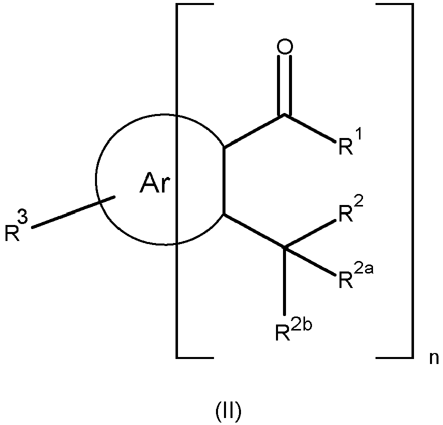
wherein
n, Ar, R¹, R²,R^{2a}, R^{2b}and R³ are as defined above; and
or a constitutional isomer or stereoisomer of the compound of formula II;
or a mixture of at least two constitutional isomers or a mixture of at least two stereoisomers or a mixture of at least one stereoisomer and at least one constitutional isomer;
and optionally further comprising
an immobilized or non-immobilized organic strong base catalyst (C) having a pKa value, as determined in acetonitrile, above 15, more particularly above 17, most particularly above 20, and preferably not more than 45, which catalyzes the re-conversion of the high energy photo isomer (B) via anion-accelerated electro-cyclic ring opening into the corresponding parent isomer (A) by setting free thermal energy as stored by (B).

In a particular embodiment, the MOST system of the invention is further characterized in that said re-conversion occurs at a temperature of at least 10°C or particularly at least 20°C, as for example in a temperature range of 10°C to 100°C, particularly 20°C to 80°C, or more particularly 20°C to 70°C or 30°C to 60°C.

According to another particular embodiment, the MOST system of the invention is provided in a molecular oxygen depleted state and, more particularly in an oxygen free, anaerobic state.

According to another particular embodiment, the MOST system of the invention is operated in a cyclic, reversible, process and preferably in and essentially oxygen free state. This may be established by operating a closed system wherein the liquid medium is stored and/or circulated under exclusion of molecular oxygen or ambient air. In order to exclude oxygen the entire system should be treated in a manner known per se in order to guarantee that oxygen is more or less quantitatively removed.

According to another particular embodiment, the organic liquid phase as used in the MOST system comprises at least one organic aprotic organic solvent, which may be polar or, more particularly nonpolar. In particular it comprises at least one aromatic solvent, more particularly selected from benzene, toluene, xylene and, most particular benzene; or cyclic or non-cyclic aliphatic solvents, like in particular und n-heptane, n-hexane or cyclohexane, or mixtures thereof. A particular group of such organic phase forming solvents has a boiling point of at most 90°C, more particularly at least 85°C. The organic liquid phase normally is provided in a state substantially depleted of water. However, traces of water do not negatively affect performance of the MOST system of the present invention.

According to another particular embodiment, the MOST system of the invention contains in its ground state the low-energy isomer (A) in a concentration range from as low as about 10 mM to a concentration which allows to obtain a maximum energy density of the system when converted to isomer (B), Optimum concentrations may be easily determined by a limited number of optimization experiments. As for example upper limits of initial concentrations of isomer (A) may be in the range of about 500 to 5000 mM, as for example in a range of up to about 4000 mM, 3000 mM, 2000 mM or 1000 mM, like about 10 to 500mM, particularly about 15 to 250mM, or about 20 to 200mM, as for example about 30 to 150, or 40 to 100mM. The same applies to the concentration of the high energy isomer (B) if the MOST system is in its final high-energy state. The same applies to any intermediate state of the MOST system for the mixture of isomers (A) and (B).

In a further particular embodiment of the MOST system of the invention, the organic strong base catalyst C is selected from organic superbases.

More particularly, said organic superbases are selected from the amidine class, the guanidine class or the phosphazene class of superbases.

In another particular embodiment of the present invention, the strong organic base C is an organic superbase comprising
a) a guanidine-type organic superbase of the general formula IIIa 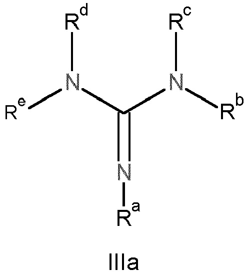 wherein
   R^{a} is selected from H, linear or branched lower alkyl, or mono- or polycyclic, aromatic or non-aromatic C₅ to C₁₆ residues, optionally substituted with at least one basic residue comprising at least one basic nitrogen atom,
   R^{b} and R^{c} independently of each other represent H, lower alkyl, optionally substituted aryl or heteroaryl, optionally substituted cycloalkyl, optionally substituted hetero-cycloalkyl, and
   R^{d} and R^{e} independently of each other represent H, lower alkyl, optionally substituted aryl or heteroaryl, optionally substituted cycloalkyl, optionally substituted hetero-cycloalkyl
      or
   one residue of R^{b} and R^{c} and one residue of R^{d} and R^{e} together with the nitrogen atoms to which they are attached to, form a heterocyclic, saturated or non-saturated 5 -to 7-membered ring; in particular such pairs of residues form an alkylene or alkenylene bridge for forming said heterocyclic ring;
      or
   R^{a} and one of the residues R^{b} and R^{c} or one of the residues R^{d} and R^{e} together with the nitrogen atoms to which they are attached to, form a heterocyclic, saturated or non-saturated 5 -to 7-membered ring; in particular such pairs of residues form an alkylene or alkenylene bridge for forming said heterocyclic ring; or of the general formula IIIb 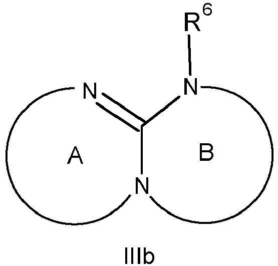 wherein
      A and B independently of each other form a 5- to 7-membered heterocyclic saturated or unsaturated ring; and
      R⁶ is selected from H or linear or branched lower alkyl,
   or
b) an amandine-type organic superbase of the general formula IIIc 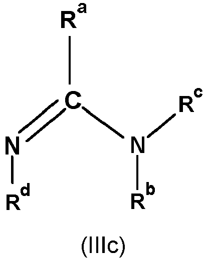 wherein
   R^{a}, R^{b}, R^{c} and R^{d} are as defined above;
      or
   R^{a} and one of the residues R^{b} and R^{c} together with the carbon or nitrogen atoms to which they are attached to, form a heterocyclic, saturated or non-saturated 5 -to 7-membered ring; in particular such pairs of residues form an alkylene or alkenylene bridge for forming said heterocyclic ring;
      and/or
   R^{d} and one of the residues R^{b} and R^{c} together with nitrogen atoms to which they are attached to, form a heterocyclic, saturated or non-saturated 5 -to 7-membered ring; in particular such pairs of residues form an alkylene or alkenylene bridge for forming said heterocyclic ring;
   or
c) a phosphazene-type organic superbase of the general formula IIId 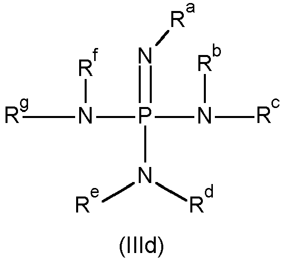 wherein,
   R^{a} is as defined above;
   R^{b}, R^{c}, R^{d} and R^{e} are as defined above,
   R^{f} and R^{g} have the same meanings as defined above for R^{b}, R^{c}, R^{d} and R^{e} and additionally
   R^{b} and R^{c} together and/or R^{d} and R^{e} together and/or R^{f} and R^{g} together form a residue of the formula

      =P(N-(lower alkyl)₂)₃

      or
   R^{b} and R^{c} together and/or R^{d} and R^{e} together and/or R^{f} and R^{g} together with the nitrogen atom which they are attached to form a 5- to 7-membered saturated or unsaturated heterocyclic moiety; in particular such pairs of residues form an alkylene or alkenylene bridge for forming said heterocyclic ring;
      or
   one residue of R^{b} and R^{c} and one residue of R^{d} and R^{e} together with the nitrogen atoms to which they are attached to, form a heterocyclic, saturated or non-saturated 5 -to 7-membered ring; in particular such pairs of residues form an alkylene or alkenylene bridge for forming said heterocyclic ring;
      or
   one residue of R^{b} and R^{c} and one residue of R^{f} and R^{g} together with the nitrogen atoms to which they are attached to, form a heterocyclic, saturated or non-saturated 5 -to 7-membered ring; in particular such pairs of residues form an alkylene or alkenylene bridge for forming said heterocyclic ring;
      or
   one residue of R^{d} and R^{e} and one residue of R^{f} and R^{g} together with the nitrogen atoms to which they are attached to, form a heterocyclic, saturated or non-saturated 5 -to 7-membered ring; in particular such pairs of residues form an alkylene or alkenylene bridge for forming said heterocyclic ring;
or an immobilized derivative of a compound of formula Illa, Illb, Illc or IIId, in particular a derivative of compound of formula IIIa, IIIb, IIIc or IIId covalently bound to an inert carrier bead, particularly microbeads in an average size range of 75 - 150 µm. Corresponding microbeads or bases covalently bound to such microbeads are commercially available as for example from company Biotage Sweden AB

According to another particular embodiment of the present invention said base C is a base comprising a guanidine type superbase selected from a compound of the general formula IV 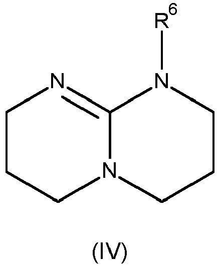 wherein
R⁶ is H or lower alkyl or a amidine-type superbase of selected from a compound of general formula V 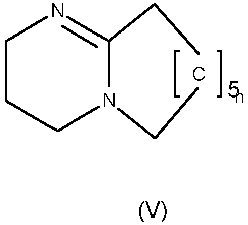 wherein
n is an integer of 1 to 4
or an immobilized derivative of a compound of formula IV or V, in particular a derivative of compound of formula IV or V covalently bound to an inert carrier bead, particularly microbeads in an average size range of 75 - 150 µm. binding to carrier beads, as for example polystyrene beads may be effected in a manner known per se via forming a linkage between the beads and a ring carbon atom of the base.

According to another, more particular embodiment the MOST system of the invention comprises
as isomer A ortho-methyl-trifluoroacetophenone (MTA) of formula VI;

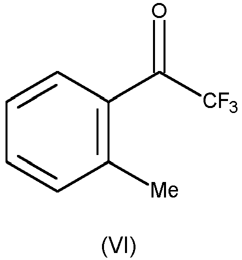

As isomer B benzo-trifluoromethylcyclobutanol (BTC) of formula VII: 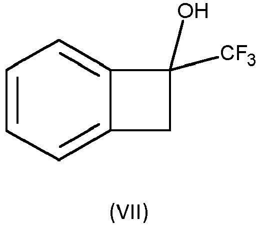 and
as organic base C a triazabicyclodecene of formula VIII 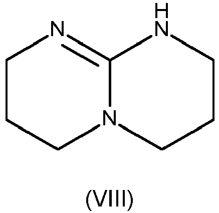
or an immobilized derivative of a compound of formula VIII, in particular a derivative of compound of formula VIII covalently bound to an inert carrier bead, particularly as polystyrene bead as defined above.

More particularly, the MOST system of the present invention is characterized by the fact that said carrier beads are non-soluble in the liquid phase of the MOST system.

### 2. The second aspect of the present invention

According to a second aspect of the invention, a method of storing solar thermal energy is provided, which method comprises exposing least one low-energy parent isomer (A) of the above general formula (II) dissolved in a liquid organic medium to solar light for a period of time sufficient to photo isomerize at least one compound A into its corresponding metastable high-energy photo isomer B of the general formula II.

In particular, said liquid medium is a medium which is in a liquid state over a wide temperature range as for example in a range of 0 to 100 °C, more particular at about 0 to 80 °C.

In a particular embodiment said medium comprises an organic solvent, in particular at least one aromatic solvent, more particularly selected from benzene, toluene, or cyclic or non-cyclic aliphatic solvents, like in particular xylole und n-heptane, n-hexane or cyclohexane, or mixtures thereof.

A storage medium of the present invention comprising at least one type of metastable high-energy photo isomer (B) solar thermal energy is stably stored at a t_{1/2} of at least 1 month, particularly at least 1 year or at least 5, 10, 50 or 100 years.

### 3. The third aspect of the present invention

According to a third aspect of the invention, a method of releasing stored solar thermal energy is provided, which method comprises contacting least one metastable high-energy photo isomer B) dissolved in a liquid organic medium with a base catalyst (C) as defined above catalyzing the terminal back-conversion of the photo isomer (B) into the corresponding parent compound (A). Thereby the stored energy as represented by the energy difference ΔH_{storage} corresponding to the energy difference between (A) and (B) is set free almost quantitatively.

### 4. The fourth aspect of the present invention

According to a fourth aspect of the invention, a method for reversibly storing solar thermal energy, which method comprises applying a MOST system as defined in the above first aspect of the invention.

More particularly, said method for reversibly storing solar thermal energy which comprises
a) exposing a low-energy storage medium comprising at least one low-energy parent isomer (A) of the above general formula (II) as defined above to solar light comprising light of a wavelength in the range of 300 to 600 nm for a period of time sufficient to photo isomerize at least one compound (A) into its metastable high-energy photo isomer (B) of the above general formula (I) as defined above in order to obtain a high-energy storage medium;
b) storing said energy-rich storage medium for a prolonged period of time;
c) contacting said high-energy storage medium with an immobilized base catalyst (C) catalyzing the terminal back-conversion of the photo isomer (B) into the corresponding parent isomer(A) by setting free thermal energy as stored by (B) in order to obtain a thermally heated storing medium; and
d) withdrawing thermal energy from said thermally heated storing medium so as to obtain the initial low-energy storage medium comprising said at least one low-energy parent isomer (A).

### 5. The fifth aspect of the present invention

According to a fifth aspect of the invention, a solar thermal energy storage device is provided, which comprises at least one metastable high-energy photo isomer (B) of the above general formula (I) as defined above.

The solar thermal energy storage device of particularly comprises a storage vessel T3 containing a storage medium comprising at least one metastable high-energy photo isomer (B) of formula (I) as defined above, which storage device further comprises a catalytic module containing immobilized catalyst C as defined above for the controlled release of stored energy upon getting into contact with the at least one metastable high-energy photo isomer (B).

### 6. The sixth aspect of the present invention

The sixth aspect of the invention relates to the use of a compound of general formula (I) as defined above and/or of a compound of general formula (II) as defined above for a reversible storing of solar thermal energy. A combination of at least one compound of general formula (I) and at least one compound of the general formula (II) is also designated as MOST couple. Dissolved in a suitable liquid medium and under conditions as further detailed herein, said MOST couple is applied in the reversible storage of solar thermal energy and, at a later stage, the controlled release of solar thermal energy under the catalytic action of a strong organic, nitrogen base as herein defined.

### 7. The seventh aspect of the present invention

A solar thermal energy capture device (SC), which comprises a transparent top layer permeable for solar light at least in a wavelength range above 300 nm, and a below said transparent top layer ab energy capture compartment (receiving tank T2) optionally provided with a solar light permeable bottom layer, further comprising an inlet for an energy capture medium comprising at least one solar light excitable organic compound A of formula (II) as defined above and an outlet for an energy capture medium enriched with at least one metastable high-energy photo isomer B of formula (I) as defined above, which energy capture medium traverses said device in a directed flow from the inlet to the outlet.

### 8. The eighth aspect of the present invention

According to an eighth aspect of the invention, a combined device for capturing solar thermal energy and solar photoelectric energy is provided, comprising an upper solar thermal capture device (SC) as defined above and a lower photoelectric compartment for capturing solar photoelectric energy comprising a photoelectric layer, as for example a (conventional) solar panel comprising a multitude of solar cells; said upper solar thermal capture device comprises an upper layer permeable for solar light and a lower bottom layer permeable for solar light, so that solar light, which enters the upper solar thermal capture device and which is not absorbed by the energy capture medium traversing said upper solar thermal capture device, is absorbed by said photoelectric layer to generate electric energy.

### 9. The ninth aspect of the present invention

According to a ninth aspect of the invention, a device for operating a MOST system as defined above is provided, which device comprises:
a) a solar thermal energy capture device SC which comprises a receiving tank T2 comprising a top layer permeable for solar light at least in a wavelength range above 300 nm, an inlet / outlet pair connected by connecting pipes 7a, 7b, 7callowing a circulating flow of a liquid phase in a circle C1, comprising at least one light excitable low-energy parent isomer A of the above general formula II, whereby isomer A is converted to its corresponding metastable high-energy isomer B;
b) a storage tank T3 connected to receiving tank T2 via connecting pipe 9 comprising a first inlet for receiving from tank T2 liquid phase enriched with metastable high-energy isomer B, and an inlet/outlet pair connected by a connecting pipe s 13a, 13b, 13cfor circulating said liquid phase enriched with metastable high-energy isomer B in a circle C2;
c) a reactor R comprising an inlet / outlet pair connected to connecting pipes 20a, 20b, 20c and containing immobilized catalyst C which catalyzes the back conversion of high energy metasabile isomer B to isomer A with release of thermal energy while ; and said liquid medium containing said metastable isomer B circulates in a circle C3;
d) a heat exchanger HE adapted to retrieve thermal energy from reactor R and to transfer the retrieved thermal energy to a heat storage tank or a heat consuming device.

The device according to a particular embodiment further comprises
e) a storage tank T1 comprising an inlet / outlet pair, wherein the inlet is connected to storage tank T3 via connecting pipe 26 for transferring liquid medium enriched with low energy isomer A to the storage tank T1; and wherein the outlet is connected via connecting pipe 27 to solar energy capture device SC.

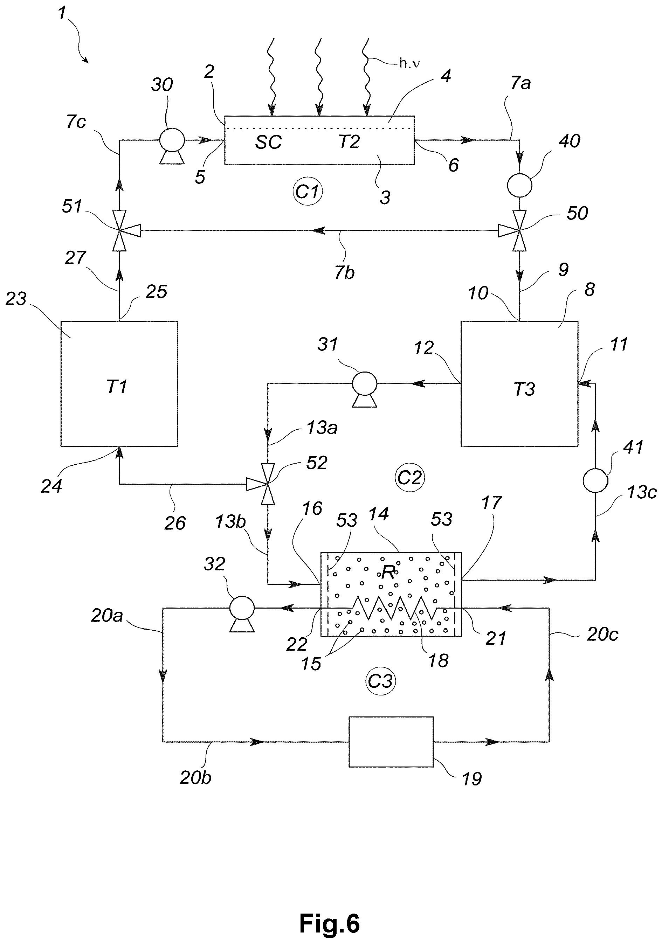

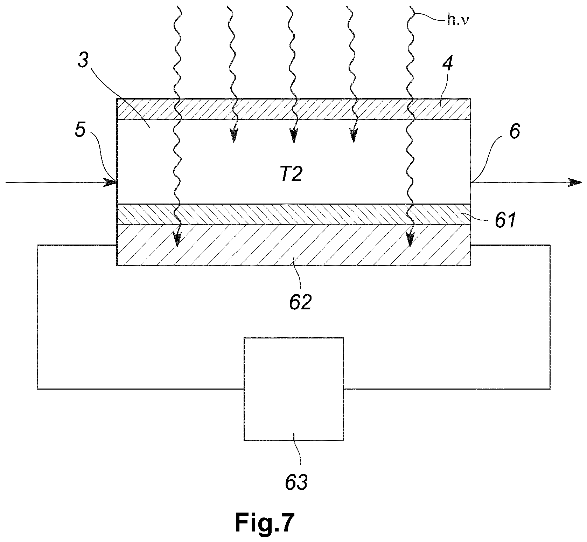

A non-limiting example of such devise is depicted in Figures 6 and 7, and further described below.

### 10. The tenth aspect of the present invention

According to a tenth aspect of the invention, a metastable high-energy photo isomer (B) of general formula (I) is provided 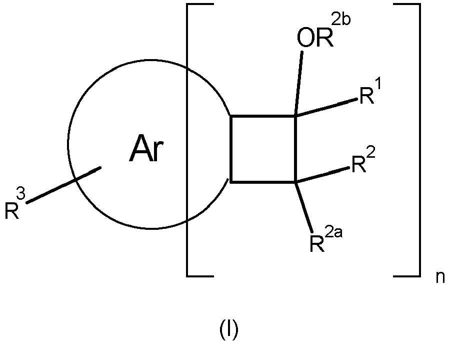 wherein,
n is an integer of 1, 2 or 3,
R¹ is selected from -C (halogen)₃₋ₐHₐ, wherein a is 0, 1 or 2, in particular 0 or 1, and halogen is selected from F, Cl or Br, in particular -CF₃; aryl; cyano; lower-alkoxy, in particular methoxy or -C(O)OR, wherein R is lower alkyl, in particular methyl;
R² and R^{2a} are identical or different and independently of each other selected from H, D, linear or branched lower alkyl or linear or branched lower-alkoxy, like methyl or methoxy; most particularly H or D;
R^{2b} is selected from H or D;
Ar represents an aromatic mono- or polycyclic, in particular mono- or bicyclic, condensed aromatic ring system or conjugated aromatic ring system, in which ring system at least one hydrogen atom of the aromatic ring system may be further substituted by one or more identical or different ring substituents R³,
wherein
R³ is selected from cyano, halogen, linear or branched lower alkyl, in particular methyl, and linear or branched lower alkoxy, in particular methoxy; and - C(O)R¹, wherein R¹ is as defined above;
or a constitutional isomer or stereoisomer of the compound of formula I;
or a mixture of at least two constitutional isomers or a mixture of at least two stereoisomers or a mixture of at least one stereoisomer and at least one constitutional isomer;
with the proviso that, when Ar is a monocyclic 6-memberd aromatic ring and R³ is missing, then n is an integer of 2 or 3; and
with the proviso that compounds of formula I are excluded; wherein R¹ is CF₃, Ar is a 6-membered aromatic ring wherein R³ is missing, R^{2a} and R^{2b} are H and R² is H or 4-n-butenyl.

### 11. The eleventh aspect of the present invention

According to an eleventh aspect of the invention, a compound excitable by solar light, in particular in the wavelength range of 300 to 600 nm, and having the general formula (II) is provided 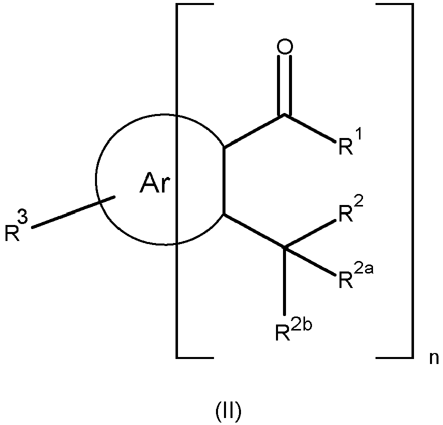 wherein
n, Ar, R¹, R², R^{2a} and R^{2b} and R³ are as defined above; and
or a constitutional isomer or stereoisomer of the compound of formula II;
or a mixture of at least two constitutional isomers or a mixture of at least two stereoisomers or a mixture of at least one stereoisomer and at least one constitutional isomer;

### D. MORE DETAILED DESCRITION OF THE INVENTION BY REFERENCE TO ISOMER PAIRS OF THE TYPE OTHO-METHYLACETOPHENONEI BENZOCYCLOBUTENOL

The present invention is based on the development of a conceptually new class of MOST couples, which is founded in the photocyclization of ortho-methylacetophenones (Fig. 1B).( P. J. Wagner, et al., J. Am. Chem. Soc. 113, 709-710 (1991). doi:10.1021/ja00002a069; N. Ishida et al., Nat. Commun. 5, 3111 (2014). doi:10.1038/ncomms4111).

The corresponding benzocyclobutenols obtained after irradiation are recognized for their high level of intramolecular strain yet remarkable stability, which motivated the inventors to further investigate their potential for efficient application in energy storage. The inventors strategy for back-isomerization builds on an electrocyclic ring opening of the corresponding benzocyclobutenolates, which, in turn, can be accessed from the respective benzocyclobutenols by deprotonation. This approach capitalizes on charge-acceleration within pericyclic reactions, an observation originally made by Evans and co-workers when studying oxy-Cope rearrangements (D. A. Evans, et al., J. Am. Chem. Soc. 97, 4765-4766 (1975). doi:10.1021/ja00849a054).

The inventors surprisingly succeeded in establishing a well-balanced isomer pair that meets the stringent photochemical and physicochemical prerequisites for a successful MOST application. Moreover, surprisingly, a highly efficient anion-accelerated ring opening reaction could be established, employing a simple organic base as the catalyst, which efficiently triggers heat release at ambient temperatures.

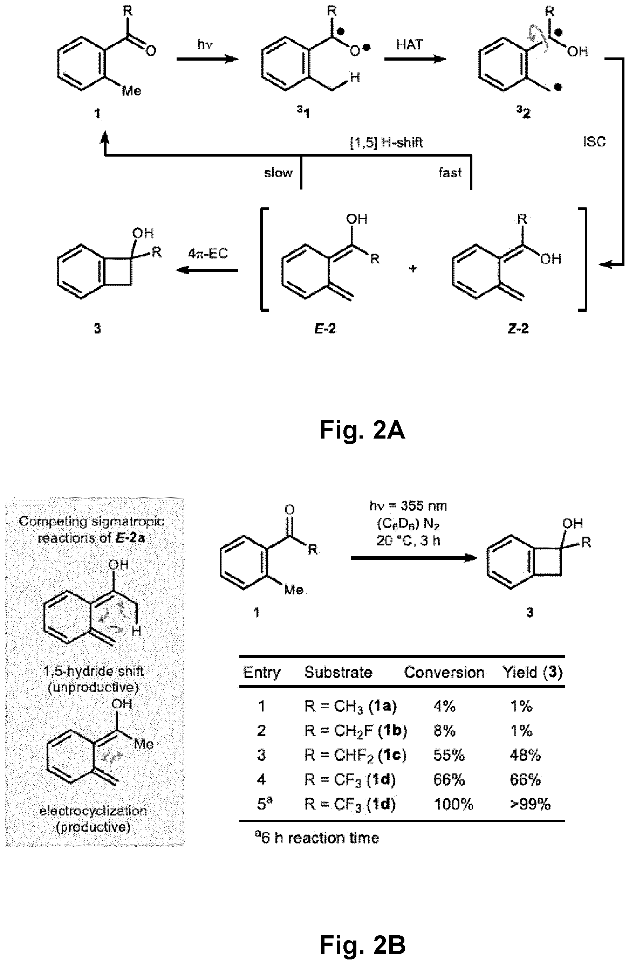

A plausible mechanism of the photocyclization of *ortho*-methylacetophenones is briefly outlined in Fig. 2A. (P. G. Sammes, Photoenolisation. Tetrahedron. 32, 405-422 (1976). doi:10.1016/0040-4020(76)80055-5; P. Klán, et al., Handbook of Organic Photochemistry and Photobiology (CRC Press, 2012), pp.627-652). serves as a crucial foundation when searching for a potential candidate for MOST application (P. G. Sammes, Photoenolisation. Tetrahedron. 32, 405-422 (1976). doi:10.1016/0040-4020(76)80055-5).

Excitation of the syn-conformer of *ortho*-methylacetophenone **1** provides the triplet ketone ³**1**, which undergoes 1,5-hydrogen atom transfer (HAT) to provide triplet biradical ³**2**. After intersystem crossing (ISC), enol isomers ***E*-2** and ***Z*-2** are forged simultaneously. The mechanistic foundation for this photoenolization process goes back to pioneering studies from the 1970s by the groups of Wagner (R. Haag, et al., Helv. Chim. Acta. 60, 2595-2607 (1977). doi:10.1002/hlca.19770600813) and Scaiano (R. D. Small et al.,J. J. Am. Chem. Soc. 99, 7713-7714 (1977). doi:10.1021/jqqa00465a055). The *Z*-isomer ***Z*-2** is known to quickly reverse to the starting material, while the *E*-isomer ***E*-2** generally possesses a longer lifetime. This principally sets the stage for a 4-π electrocyclization (EC) towards the desired benzocyclobutenol **3.** However, in the case of *ortho*-methylacetophenone **1a** (R = Me), the photocyclization is characterized by low yields and thus not suitable for the development of a MOST system (Fig. 2B, Entry 1) (A. Sandvoß, et al., Org. Lett. 25, 5795-5799 (2023). doi:10.1021/acs.orglett.3c02048). The inventors presumed that the inefficiency of this process is based on a competitive 1,5-hydride shift of isomer ***E*-2a** (Fig. 2B, grey box) (K. lida, et al., J. Org. Chem. 64, 7407-7411 (1999). doi:10.1021/jo990705n).

For this reason, initiated further optimization by hydrogen displacement to inhibit the unproductive reversion to starting material. Surprisingly, fluorine emerged as favored option for this endeavor due to the unreactive nature of the C-F bond. Moreover, fluorine fulfills the inventors' aim to identify a low molecular weight candidate to uphold a high energy density. However, the introduction of one fluorine atom **(1b)** led to low product yields (Entry 2), which can be explained by slow keto-enol tautomerism of the photogenerated enol of **1b.** In contrast, difluoroacetophenone **1c** and trifluoroacetophenone **1d** showed significantly better results, with a yield of 49% and 66%, respectively (Entries 3 and 4). Since benzocyclobutenols such as **3d** do not absorb light beyond 280 nm, the occurrence of a photostationary state is effectively obviated in this sequence. Thus, **3d** could, surprisingly, be obtained in >99% yield by extending the reaction time (Entry 5).

The inventors also surprisingly observed, that the reaction also performed well when using a 370 nm or 390 nm light emitting diode (LED), displaying first order kinetics with no indications of side reactions or decomposition, as monitored by ¹⁹F nuclear magnetic resonance (NMR) spectroscopy (data not shown).

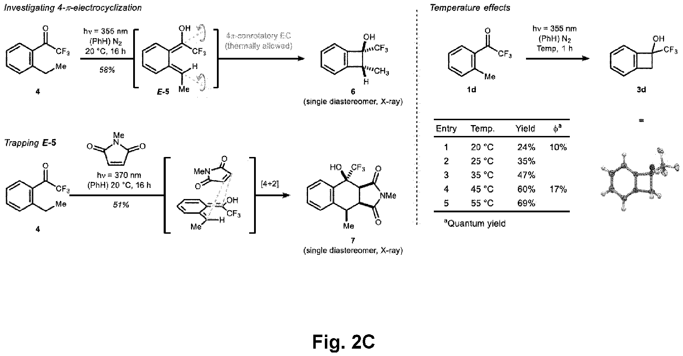

To decipher the mechanism of the pivotal 4π electrocyclic ring closure towards **3d,** The inventors synthesized trifluoroacetophenone **4** and subjected it to the optimized conditions (Fig. 2C). Benzocyclobutenol **6** was obtained as a single diastereomer, signifying a conrotatory ring closure of ***E*-5,** consistent with a thermal reaction pathway. The subsistence of ***E*-5** as a reaction intermediate was validated through a trapping experiment with *N*-methylsuccinimide, yielding tricycle **7** as the sole product (N. C. Yang, et al., J. Am. Chem. Soc. 83, 2213 (1961). doi:10.1021/ja01470a053; L. Dell'Amico, et al., Angew. Chem. Int. Ed. 55, 3313-3317 (2016). doi:10.1002/anie.201509472; J. Y. J. Wang, et al., J. Am. Chem. Soc. 144, 1023-1033 (2022). doi:10.1021/jacs.1c12174).

Based on these results, the inventors assumed that raising the reaction temperature will facilitate the EC and thus improve the conversion to benzocyclobutenol **3d.** Indeed, they surprisingly observed an increase in rate when gradually raising the reaction temperature of the photocyclization (Fig. 2C, right). Notably, this surprising improvement correlated well with the measured quantum yields (ϕ) of the isomerization process, which were determined at the excitation wavelength of 355 nm with a combined laser flash photolysis (LFP)-NMR technique (data not shown). To explain this temperature-dependent quantum yield, the inventors suspect that the EC is more drastically facilitated by the temperature change than the unproductive reversion to starting material via bimolecular processes. An improved quantum yield at elevated temperatures is a valuable asset for large scale MOST applications, where heating can be a side effect due to intense photoirradiation or insufficient cooling. X-ray analysis of the product revealed an elongated C-C bond of 1.58 Å, highlighting the distorted character of the strained entity.

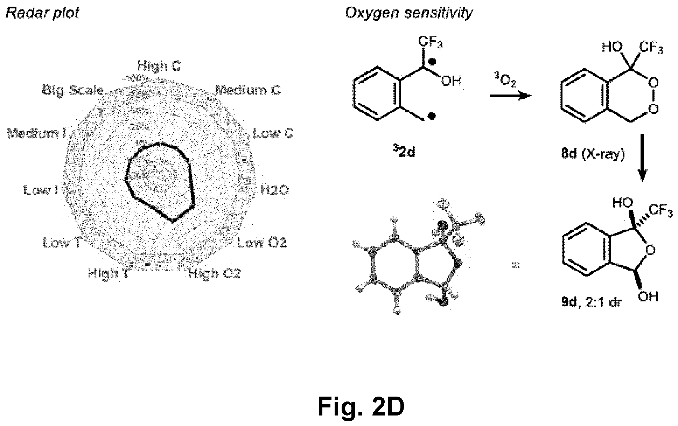

Next, the inventors evaluated the reaction's robustness. While the reaction was insensitive to changes in temperature, light intensity, water-content, or scale, aerobic conditions led to drastically reduced yields as indicated by the radar diagram depicted in Fig. 2D (L. Pitzer, et al., Angew. Chem. Int. Ed. 58, 8572-8576 (2019). doi: 10.1002/anie.201901935). Oxygen is a known interferent of reaction intermediates during photoenolization (P. Yates, et al., Tetrahedron Lett. 9, 5389-5392 (1968). doi:10.1016/S0040-4039(00)89786-5). When performing the reaction under air or oxygen atmosphere, peroxide **8d** was formed, which slowly decomposed to hemiacetals **9d** explaining the sluggish reaction outcomes. Control experiments suggest that **8d** is formed by a spin-allowed quenching of the triplet biradical ³**2d** by ³O₂ (data not shown).

The inventors further studied the impact of modifications to the *ortho-*substituent and electronic perturbations of the aromatic ring on the reaction outcome. While the inventors were able to access 12 previously unknown benzocyclobutenols, the parent compound **3d** remained the best candidate for MOST application based on its high energy density, reaction rate, and the absence of side reactions (see details in experimental part). When it comes to solvent selection, benzene proved to be the most effective, enabling the consistent generation of multigram quantities at up to 1 M concentrations (see details in experimental part).

To further validate the key mechanistic steps proposed in Fig. 2A, an in-depth LFP analysis was conducted for **1d** at 355 nm, which allowed the detection of photoenol ***Z*-2d** as a short-lived intermediate (τ ~ 0.50 µs) and photoenol ***E*-2d** as a relatively long-lived intermediate. Assuming similar difference extinction coefficients, the ratio of ***Z*-2d** and ***E*-2d** formed after the laser pulse is estimated to be ~80:20. This is in good accordance with the measured quantum yield of 17% under the prerequisite that only ***E*-2d** undergoes efficient EC.

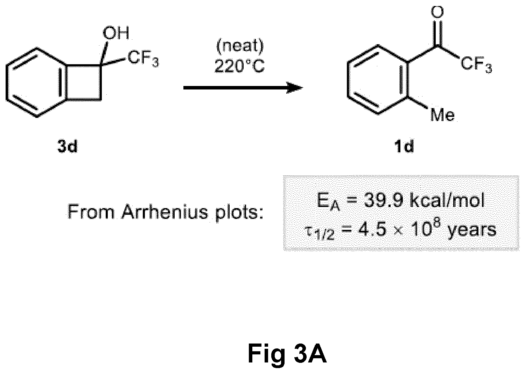

Having a promising candidate in hand, the inventors started looking at the electrocyclic ring opening. Benzocyclobutenol **3d** exhibited an exceptional thermal stability showing no signs of decomposition even after extended heating at 150 °C. This result is in stark contrast to other benzocyclobutenols, which are known to undergo electrocyclic ring opening at 100-110 °C (B. J. Arnold, et al., J. Chem. Soc., Perkin Trans. 1, 415 (1974). doi:10.1039/P19740000415; N. Ishida, et al., J. Am. Chem. Soc. 134, 17502-17504 (2012). doi:10.1021/ja309013a). However, when heating **3d** to 220 °C in a closed vial, clean back-isomerization to the starting material was observed (Fig. 3A). An activation barrier of 39.9 kcal/mol was derived from a conversion-time-plot of the ring-opening event.

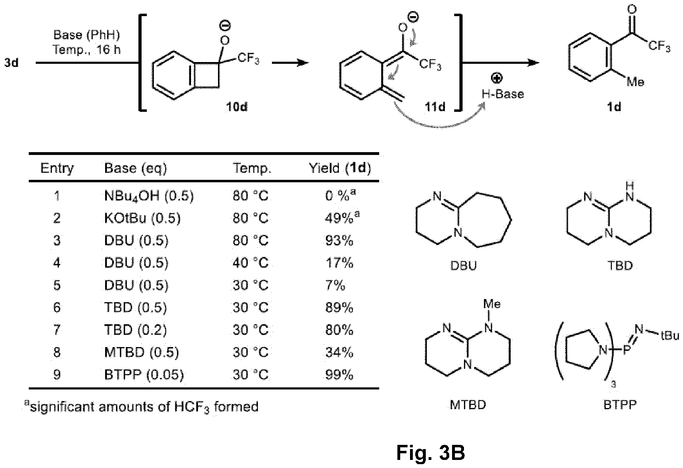

This characteristic renders **3d** attractive for long-term energy storage and safe transportation with an extrapolated thermal half-life of 4.5 × 10⁸ years, clearly distinguishing it from other MOST systems. As opposed to the high stability of benzocyclobutenol **3d,** its anion readily underwent ring opening (Fig. 3B, 10d → **11d**) (M. P. Cava, et al., J. Am. Chem. Soc. 82, 652-654 (1960). doi:10.1021/ja01488a038; W. Choy, et al., J. Org. Chem. 53, 5796-5798 (1988). doi:10.1021/jo00259a041). The torqueselectivity of the process is known to follow outwards rotation of the hydroxy group based on pioneering computational studies by Houk and coworkers (C. W. Jefford, et al., J. Am. Chem. Soc. 114, 1157-1165 (1992). D oi:10.1021/ja00030a005). When potassium *tert*-butoxide was used as a base at 90 °C, 49% of acetophenone **1d** was obtained along with minor amounts of decomposition materials (Fig. 3B, Entry 1). Hydroxyl bases were not suitable as they triggered a consecutive haloform reaction as evidenced by fluoroform evolution (Entry 2).

However, the progression to organic superbases (T. R. Puleo, et al., Research. Chem. Eur. J. 27, 4216-4229 (2021). doi: 10.1002/chem.202003580) surprisingly resulted in a notable further improvement of the MOST system of the invention. 1,8-Diazabicyclo[5.4.0]undec-7-ene (DBU) catalyzed an immaculate ring-opening reaction (Entry 3). Moreover, fine-tuning of the organic base, catalyst loading (to about 5mol%), and reaction time (up to 16 hours) allowed us to maintain good conversion while dropping the reaction temperature to 30 °C (Entries 5-9).

Optimal results were achieved by either using 1,5,7-triazabicyclo(4.4.0)dec-5-ene (TBD) or *tert*-butylimino-tri(pyrrolidino)phosphoran (BTPP) as bases and correspond to a further surprising rate acceleration of 10⁶-10⁷ compared to the uncatalyzed ring opening of **3d.**

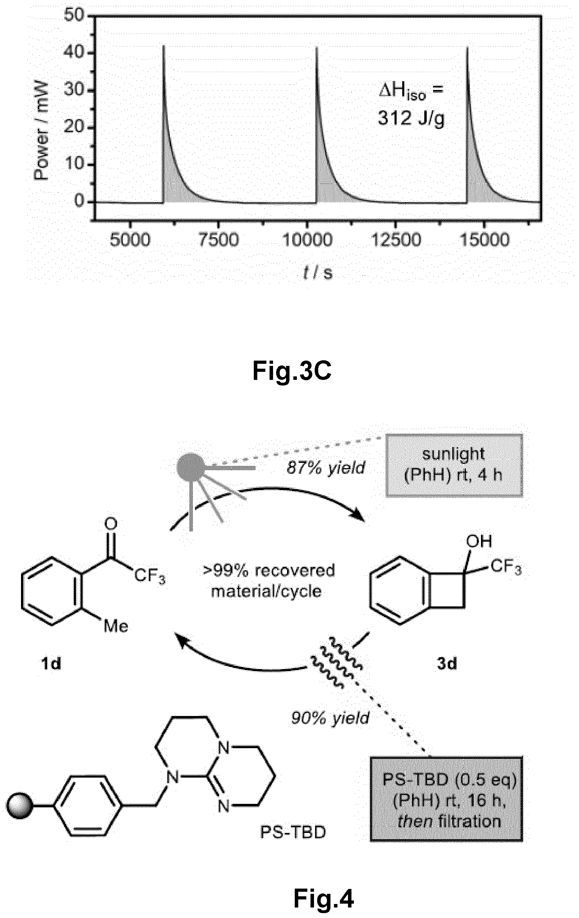

Subsequently, we analyzed the thermochemistry of the catalytic process using a reaction calorimeter (Fig. 3C). We obtained an average of 312 J/g of heat release for the opening event, significantly surpassing the heat stored in solar-warmed water (ΔT = 50 °C, ΔH = 209 J/g). The measured energy density is also confirmed by our DFT calculations (data not shown). Although the stored energy is somewhat lower than the archetypal quadricyclane ⇄ norbornadiene pair (14.4 kcal/mol vs. 21.2 kcal/mol in toluene) (D. S. Kabakoff, et al., J. Am. Chem. Soc. 97, 1510-1512 (1975). doi:10.1021/ja00839a039), the latter cannot operate under sunlight conditions due to its weak absorptivity in the UVA spectral region.

The progression to sunlight irradiation and the establishment of a cyclable process are important measures for the evaluation of MOST systems. In accordance, the inventors subjected trifluoroacetophenone **1d** to sunlight irradiation (Fig. 4). An average yield of 87% was obtained with no signs of material deterioration or side reactions, underpinning the reaction's robustness (For detailed experimental procedures and set-ups, please refer to the experimental part). To initiate back-isomerization and heat release, the inventors established a protocol using a polystyrene (PS)-immobilized TBD base, which can be conveniently removed through simple filtration after the reaction has stalled. Thus, the inventors surprisingly were able to directly re-expose acetophenone **1d** to sunlight irradiation, ensuring the system's cyclability. An average yield of 90% was achieved when using the polymersupported TBD base, which performed equally well as its low-molecular counterpart enabling a material recovery of >99% per cycle.

### E. FURTHER PARTICULAR EMBODIMENTS

### 1. Examples of Organic Superbases

According to particular embodiments of the present invention it is preferred to apply, for the reconversion of distorted thermal energy into free thermal energy a so-called organic superbase. Such superbases are divided up into 3 different classes, the class of amidines, the class of guanidines and the class of phosphazenes

### 1.1 Particular amindine based superbases

A first preferred group of amidine based superbases is represented by the general formula 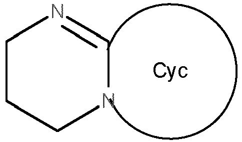 wherein
Cyc represents a 5- to 7-membered non-saturated or unsaturated heterocyclic ring

A particular example thereof is represented by the following chemical formula 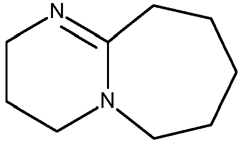 DBU (pKa 24,3)

A second preferred class of amidine based superbases is represented by the general formula: 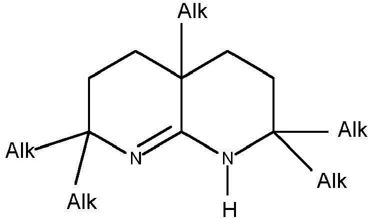 wherein
Alk independently of each other is straight-chain or branchedlower alkyl, particularly methyl or ethyl, more particularly methyl.

### 1.2 Particular guanidine based superbases

A first group of guanidine based superbases, is represented by the following formula: 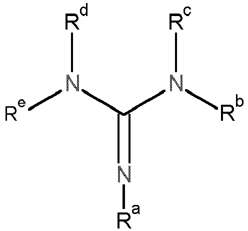 wherein
R^{b} R^{b}, R^{c}, R^{d} and R^{e} independently of each other represent straight-chain or branched lower alkyl, in particular R^{a} is selected from hydrogen or t-butyl and the remaining residues R^{b}, R^{c}, R^{d} and R^{e} are each methyl.

A second group of guanidine based superbases, is represented by the following formula: 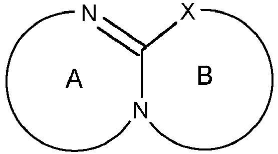 wherein
A and B independently of each other represent a 5- to 7- membered heterocyclic ring and
X represents the group >NH or >NR ,
   wherein
   R represents a straight-chain or branched lower alkyl residue

Particular examples of suitable guanidine bases, and their respective pKa values are listed in Table 1 below:

**Table 1:**

| **No.** | **Formula** | **pKₐ** |
|---|---|---|
| 11 | 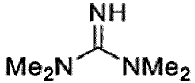 | 23.3 |
| 12 TBD | 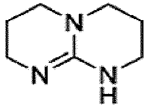 | 25.96 |
| 13 | 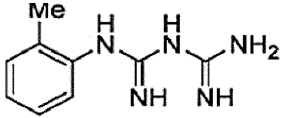 | 19.43 |
| 14 | 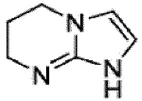 | 24.55 |
| 15 | 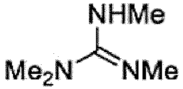 | 17.1 |
| 16 MTBD | 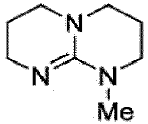 | 25.43 |
| 17 | 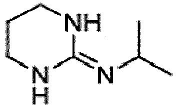 | - |
| 18 | 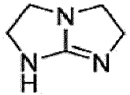 | - |
| 19 | 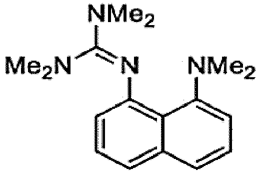 | 24.6 |
| 20 | 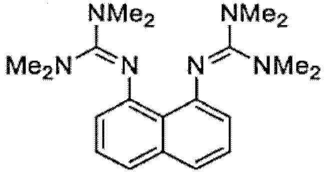 | 25.4 |
| 21 | 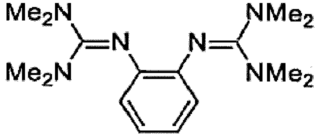 | 24.0 |
| 22 | 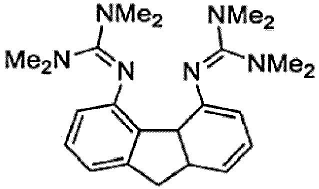 | 27.8 |
| 23 | 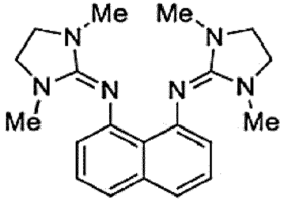 | 23.0 |
| 24 | 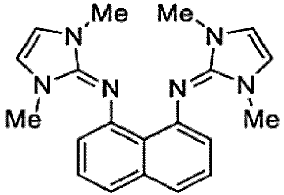 | 25.8 |

pKa correspond to the conjugated acid of the base and the values are determined in MeCN

### 1.3 Particular phosphazene based superbases

A particular type of phosphazene superbases is represented by the formula 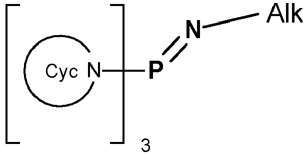 wherein
Alk represents a straight chain or branched C₁- C₄ alkyl group, and
Cyc represents together with the N atom to which it is attached, a 5- to 7- membered saturated or non-saturated nonaromatic or aromatic ring group

More particularly, the superbase is BTPP (pKa = 28,4) of the formula

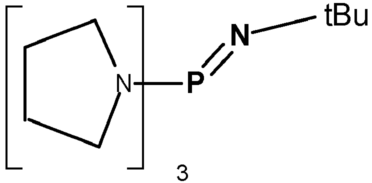

As further examples of suitable phosphazene superbases there may be mentioned the following compounds as referred to in Puelo et al (Chem Eur J 2021,27, 4216-4229):

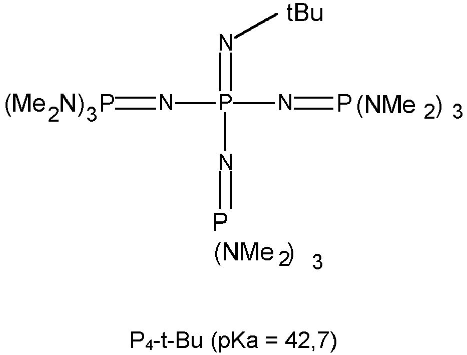

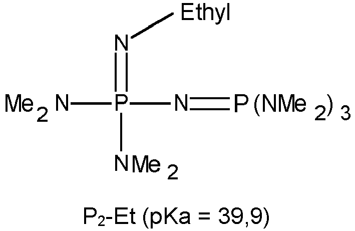

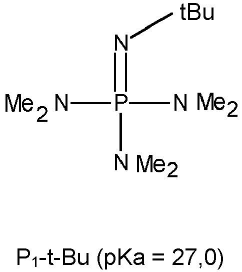

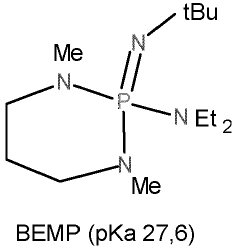

### 2. Particular low-energy parent isomers A

For the compounds depicted below any constitutional isomer of the particular depicted compound and any stereoisomer thereof either as a mixture of at least two stereoisomers or in the form of a pure stereoisomer is encompassed, or any constitutional isomer either as a mixture of at least two constitutional isomers or im the form of a pure constitutional isomer, or as a mixture of at least one stereoisomer and at least one constitutional isomer.

### 2.1 Mononuclear Low-energy Isomers A

### 2.1.1 Single-functionalized Isomers A

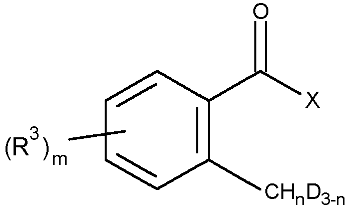

wherein
X = CF₃, CHF₂, CN, COOR
   with R = lower alkyl, in particular methyl
R³ = cyano, halogen, methyl or methoxy;
n = 0, 1, 2 or 3, in particular 3, and
m = 1, 2 or 3, in particular 1

As particular examples there may be mentioned: 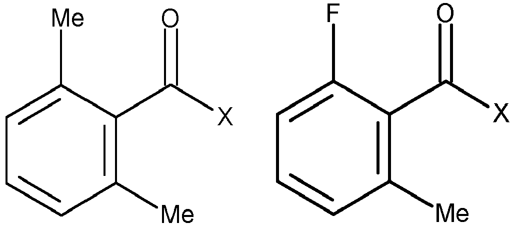 wherein
X = CF₃, CHF₂, CN, COOR
   with R = lower alkyl, in particular methyl, and
Me = CHₙD₃₋ₙ
with n = 0, 1, 2 or 3, in particular 3,

### 2.1.2 Double-functionalized Isomers A

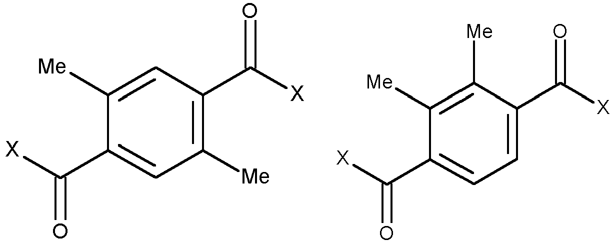

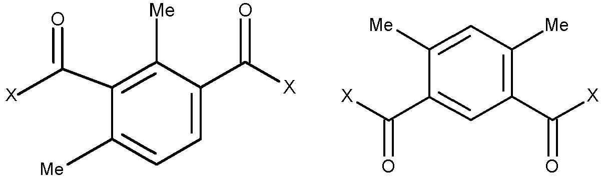

wherein
X = CF₃, CHF₂, CN, COOR
   with R = lower alkyl, in particular methyl, and
Me = CHₙD₃₋ₙ
   with n = 0, 1, 2 or 3, in particular 3,

As particular example there may be mentioned:

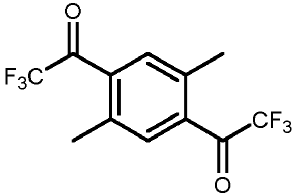

### 2.1.3 Triple-functionalized Isomers A

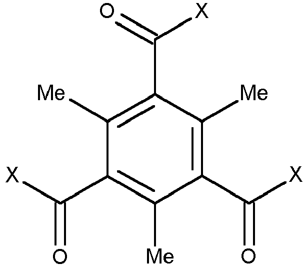

wherein
X = CF₃, CHF₂, CN, COOR
   with R = lower alkyl, in particular methyl, and
Me = CHₙD₃₋ₙ
   with n = 0, 1, 2 or 3, in particular 3,

### 2.2 Polynuclear low-energy Isomers (A)

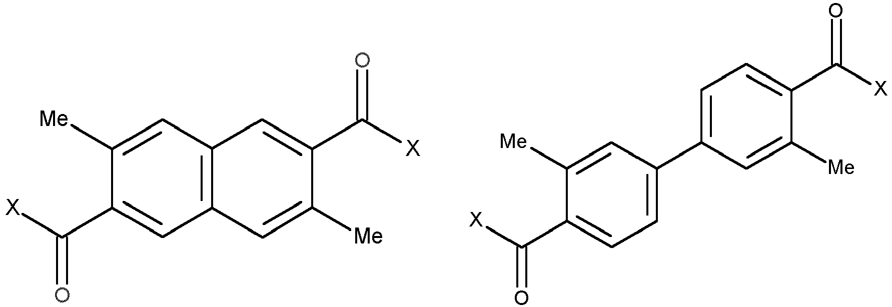

wherein
X = CF₃, CHF₂, CN, COOR
   with R = lower alkyl, in particular methyl, and
Me = CHₙD₃₋ₙ
   with n = 0, 1, 2 or 3, in particular 3,

### 3. Particular high-energy isomers (B)

For the compounds depicted below any constitutional isomer of the particular depicted compound and any stereoisomer thereof either as a mixture of stereoisomers or in the form of a pure stereoisomer is encompassed.

### 3.1 Mononuclear high--energy Isomers (B)

### 3.1.1 Single-functionalized Isomers (B)

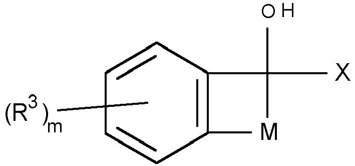

wherein
X = CF₃, CHF₂, CN, COOR
   with R = lower alkyl, in particular methyl, and
M = CHₙD₂₋ₙ
   with n = 0, 1, 2 or 3, in particular 3,
R³ = cyano, halogen, methyl or methoxy;
m= 1, 2 or 3, in particular 1.

### 3.1.2 Double-functionalized Isomer (B)

a) Para double-functionalized constitutional isomers 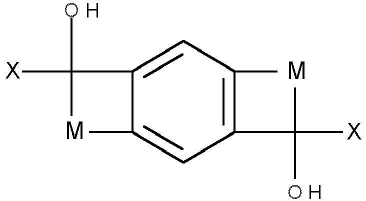 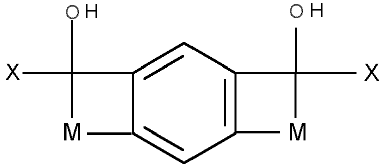 wherein
   X = CF₃, CHF₂, CN, COOR
      with R = lower alkyl, in particular methyl, and
   M = CHₙD₂₋ₙ
      with n = 0, 1, 2 or 3, in particular 3,
b) Ortho double-functionalized 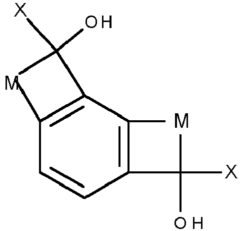 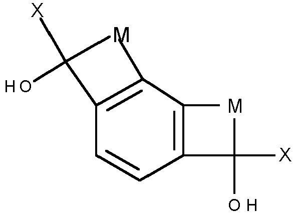 wherein
   X = CF₃, CHF₂, CN, COOR
      with R = lower alkyl, in particular methyl, and
   M = CHₙD₂₋ₙ
      with n = 0, 1 or 2, in particular 2.

### 3.1.3 Triple functionalized Isomer (B)

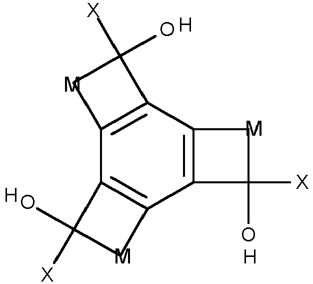

wherein
X = CF₃, CHF₂, CN, COOR
   with R = lower alkyl, in particular methyl, and
M = CHₙD₂₋ₙ
   with n = 0, 1 or 2, in particular 2. 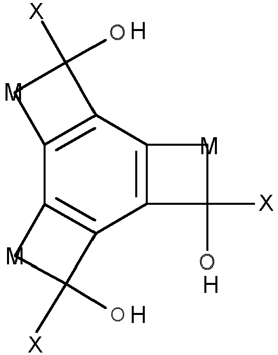 wherein
   X = CF₃, CHF₂, CN, COOR
      with R = lower alkyl, in particular methyl, and
   M = CHₙD₂₋ₙ
      with n = 0, 1 or 2, in particular 2. 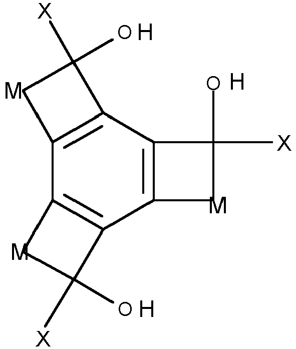
   wherein
   X = CF₃, CHF₂, CN, COOR
      with R = lower alkyl, in particular methyl, and
   M = CHₙD₂₋ₙ
      with n = 0, 1 or 2, in particular 2.

### 3.2 Polynuclear Isomers (B)

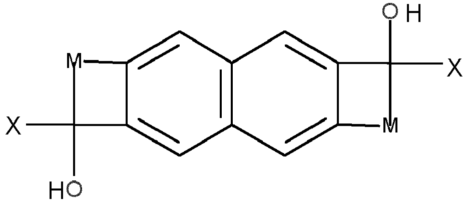

wherein
X = CF₃, CHF₂, CN, COOR
   with R = lower alkyl, in particular methyl, and
M = CHₙD₂₋ₙ
   with n = 0, 1 or 2, in particular 2. 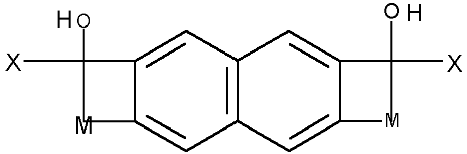
wherein
X = CF₃, CHF₂, CN, COOR
   with R = lower alkyl, in particular methyl, and
M = CHₙD₂₋ₙ
   with n = 0, 1 or 2, in particular 2. 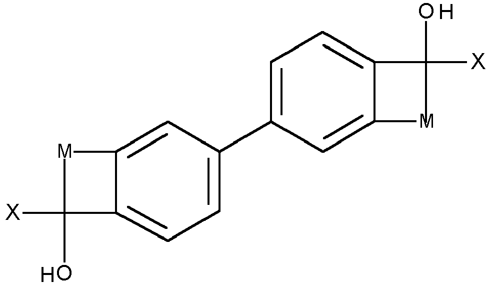
wherein
X = CF₃, CHF₂, CN, COOR
   with R = lower alkyl, in particular methyl, and
M = CHₙD₂₋ₙ
   with n = 0, 1 or 2, in particular 2. 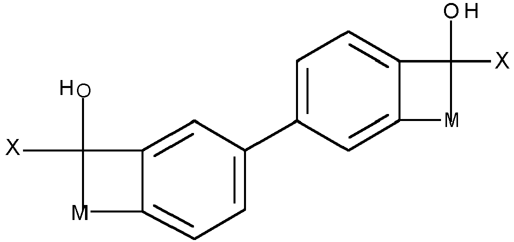
wherein
X = CF₃, CHF₂, CN, COOR
   with R = lower alkyl, in particular methyl, and
M = CHₙD₂₋ₙ
   with n = 0, 1 or 2, in particular 2.

### 4. Particular examples of MOST couples (A) and (B)

In the following table, non-limiting examples of MOST couples of the invention (with Ar = benzyl in above formulae I and II) are summarized:

| | **Low energy Isomer (A)** | **High energy Isomer (B)** |
|---|---|---|
| a) | 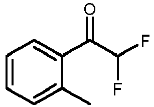 | 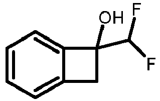 |
| b) | 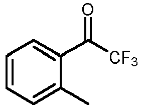 | 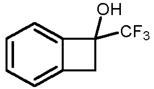 |
| c) | 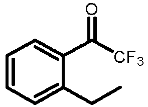 | 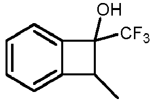 |
| d) | 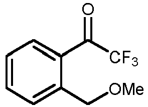 | 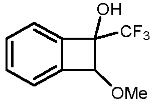 |
| e) | 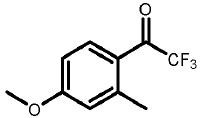 | 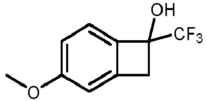 |
| f) | 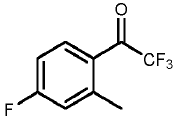 | 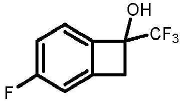 |
| g) | 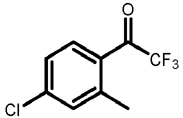 | 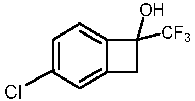 |
| h) | 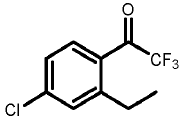 | 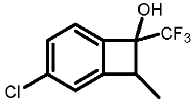 |
| i) | 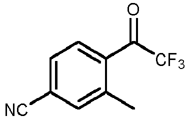 | 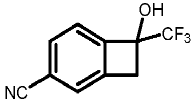 |

### 5. Devices for operating a MOST system of the present invention

A non-limiting example of a device for performing a method for reversibly storing solar thermal energy will now be explained with reference to Figure 6:
Therein the device 1 for operating a MOST system of the present invention is shown. It comprises a solar thermal energy capture device 2 comprising a receiving tank 3 (T2) for taking up a liquid medium containing at the start of the process predominantly the solar light - excitable low-energy parent isomer (A). Solar light penetrating the top layer 4 of the capture device 2 converts said isomer (A) at least in part into the metastable high-energy isomer (B), while the liquid medium driven by pump 30 traverses the capture device 2 in a directed flow between inlet 5 and outlet 6 of the device. Driven by pump 30 the liquid medium circulates via connecting pipes 7a, Tb and 7c and three-way valves 50 and 51 under the control of a 1^{st} optical sensor 40 measuring, for example, the content of high-energy isomer (B) in the circulating liquid medium. The medium is circulated in said first circle C1 (also designated energy uptake circle) until the concentration of the high energy isomer (B) has reached a predetermined upper level detected by sensor 40. Sensor 40 is then acting on three-way valve 50 switching to pipe 9 so that the liquid medium enriched with high-energy isomer (B) is transferred to storage tank 8 (T3). If needed said energy uptake circle C1 may be repeated so that the total amount of high energy isomer (B) in storage tank 8 further increases.

If thermal energy is to be released, a thermal heat release circle C2 is activated. Driven by pump 31 via circulating pipes 13 a, 13b and 13c the liquid medium enriched with high-energy isomer (B) is circulated via outlet 12 and inlet 11 of storage tank 8 through a reactor 14 via a first pair of inlet and outlet (16, 17) of the reactor 14. Said reactor is prefilled with micro particles carrying immobilized basic catalyst 15. Within the reactor 14 means 53 are provided which are permeable to the liquid medium and isomers (A) and (B) dissolved therein but impermeable to the immobilized base catalyst 15. Through the action of the said catalyst 15 a terminal back isomerization of isomer (B) to isomer (A) is catalyzed setting free the stored thermal energy of isomer (B) while increasing the temperature of the liquid medium circulating through the reactor 14. Driven by pump 32 a heat exchange medium is guided through the reactor 14 where, between the second pair of inlet and outlet 21 and 22 a heat exchanger 18 is provided, transferring heated medium circulating in the heat exchange circle C3 to module 19 which may be for example a heat storage tank or a heat energy consuming device or system, as for example the heating system of a building. After said reconversion process in the reactor 14 is terminated and the thermal energy is transferred to module 19 the liquid medium now predominantly containing the low energy isomer (A) is pumped via storage tank 8 (T3), three-way valve 52 and connecting pipe 26, back to storage tank 23 (T1), equipped with a pair of inlet and outlet (24, 25) After completing said transfer three-way valve 52 closes pipe 26 and opens three-way valve 51. Via connecting pipe 7c the content of storage tank 23 (T1) is pumped by pump 30 back into the capture device 2 so that the isomerization process of low energy isomer (A) to high-energy isomer (B) can start anew.

Figure 7 shows an alternative embodiment of a solar energy capture device of Figure 6. According to Figure 7 a combined device is provided which allows the capture of solar thermal energy as well as of photoelectric energy. While solar energy is collected in tank T2 equipped with a pair of inlet and outlet (5,6) for a directed flow of solar energy capture medium through said tank T2 solar light penetrating the top layer 4 will be partially absorbed by the solar energy capture medium in order to convert low energy isomer (A) to energy isomer (B). A proportion of the solar light which is not absorbed by the capture medium is penetrating through tank T2, will exit tank T2 through its light permeable lower layer 61 and will be absorbed by the photo electric collector 62 provided below said tank T2. The electric energy generated may either be stored in module 63 which in that case would be a battery or may directly be consumed by module 63 which alternatively may for example be provided as a device consuming electrical energy.

The invention is further illustrated by the following non-limiting examples.

### Experimental part

### Materials and Reaction Set-Up

Chemicals were purchased from *Alfa Aesar, Acros Organics, Sigma Aldrich, BLDpharm, FluoroChem, Carbolution* or *ABCR* and (unless otherwise stated) used as received.

All reactions involving air or moisture sensitive reagents were carried out in oven-(125 °C) and flame-dried glassware under nitrogen atmosphere using standard *Schlenk* techniques. Dry solvents were collected from an *MBraun MB SPS-800* (Et₂O: MB-KOL-A and MB-KOL MT2-250, THF: 2 × MB-KOL MT2-150°C, CH₂Cl₂: 2 × MB-KOL-A). A positive argon pressure was used to pass the solvents through the columns.

Unless otherwise noted, all work-up and purification procedures were carried out with pre-distilled technical grade solvents. Purification was performed either with standard column chromatography techniques using *Geduran*^{®} Si 60 silica gel (0.063-0.200 mm, *Merck*), on an automated flash chromatography system *Biotage Isolera One* utilizing *Biotage Sfär Silica D-Duo* 60 µm columns (5 g, 25 g, 100 g) or on an automated flash chromatography system Teledyne Isco with *Biotage Sfär Silica C18-Duo* 100 Å 30 µm columns (12 g).Glass silica gel plates 60 F254 (*Merck*) were used for analytic thin layer chromatography applying either UV light (254/366 nm), KMnO₄ (1.5 g KMnO₄, 5 g NaHCO₃ and 5 mL NaOH 10% in 200 mL H₂O), CAM (0.5g Ce(NH₄)₂(NO₃)₆ and 24.0 g of (NH₄)₆Mo₇O₂₄·4H₂O, 28 mL H₂SO₄ in 200 mL H₂O) for detection.

Photochemical reactions were performed in a *Luzchem* LZC-ORG photoreactor with 10 × 8 Watt *Luzchem* LZC-355 mercury lamps or a 40 W 370 nm Gen 2 KSPR160L Kessil LED.

### Analytical Methods

Melting points (**M.P.**) were measured on a *Büchi* B-540 melting-point apparatus and are reported uncorrected.

Infrared (**IR**) spectra were obtained on a Tensor 27 spectrometer (*Bruker*) using a diamond ATR unit and are reported in wavenumbers (cm⁻¹). Bands are characterized as broad (br), strong (s), medium (m), and weak (w).

Nuclear magnetic resonance (**NMR**) spectra were recorded by the analytical department of the Department Chemie at Johannes Gutenberg-Universität Mainz. The following spectrometers were used: Avance III HD 300 *(Bruker),* Avance II 400 (*Bruker*), Avance III HD 400 (*Bruker*), and Avance III 600 equipped with a cryo-probe head (*Bruker*). Spectra were recorded at 22 °C (unless otherwise noted). Chemical shifts are reported in ppm with the solvent resonance as the internal standard (¹H NMR CHCl₃: *δ* = 7.26 ppm, C₆HD₅: *δ* = 7.16 ppm, (CHD₂)(CD₃)SO: *δ* = 2.50 ppm; CHD₂CN: : *δ* = 1.94 ppm, ¹³C NMR CDCl₃: *δ* = 77.16 ppm, C₆D₆ *δ* = 128.06 ppm, (CD₃)₂SO: *δ* = 39.5 ppm, CD₃CN: *δ* = 118.26 ppm). Chemical shifts of ¹⁹F NMR are referenced to internal or external standards. The data is reported as follows: chemical shift, multiplicity (s = singlet, d = doublet, t = triplet, q = quartet, p = pentet, br = broad, m = multiplet or combinations of these), coupling constants (Hz) and integration. High Resolution Mass Spectrometry (**HRMS**) was performed by the analytical department of the Department Chemie at Johannes Gutenberg-Universität Mainz. Spectra were recorded on a *Thermo-Fisher Scientific* DFS (GC-MS, ionization *via* electron ionization (EI) or chemical ionization (Cl)) or on an *Agilent* 6545 Q-ToF (LC-MS, ionization *via* electron spray ionization (ESI), atmospheric-pressure chemical ionization (APCI)). Signals are reported as mass to charge ratio *m*/*z.*

Differential scanning calorimetry (**DSC**) was performed using a *µ*RC^{®} micro Reaction Calorimeter (*Thermal Hazard Technology, THT*) and analysis was conducted using the *µ*RC *Analysis software 2.6.5.*

### A) Synthesis of Starting materials

General Procedure **A** for the preparation of 2,2,2-trifluoroacetophenones from halogenated arenes with lithium organyls:
A halogenated arene (1.00 eq.) was dissolved in dry Et₂O or THF (0.2 M) under inert gas atmosphere and was cooled to -78 °C at which temperature *t*-BuLi (2.05 eq.) was added dropwise. After 30 min, ethyl trifluoroacetate (1.10 eq.) was added dropwise and the mixture was stirred at -78 °C for 3 h. NH₄Cl sat. was added at that temperature and the solution was diluted with Et₂O and allowed to warm up to rt. The organic phase was separated, and the aqueous phase was extracted with Et₂O (3x). The combined organic fractions were dried over MgSO₄ and the solvent was removed under reduced pressure. The products were purified *via* flash chromatography (FC) and bulb-to-bulb distillation (device: BÜCHI GKR 50, 1.1 mbar pressure, 25 °C up to 250 °C).

. Bulb-to-bulb distillation was found to be crucial to achieve reproducible reactivity in the irradiation.

### Example 1: 2-Fluoro-1-(o-tolyl)ethan-1-one [1b]

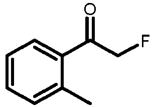

Following general procedure A with minor alterations using 2-bromotoluene (2.05 g, 1.44 mL, 12.0 mmol,1.00 eq.), t-BuLi (1.54 g, 14.1 mL, 24.0 mmol, 1.70 M, 2.00 eq.) and 2-fluoroacetonitrile (1.06 g, 1.00 mL, 18.0 mmol, 1.50 eq.) in Et₂O (50 mL). The desired product was obtained after FC (pentane/Et₂O, 60:40) and bulb-to-bulb distillation (130 °C, 1.1 mbar) as a colorless oil (456 mg, 3.00 mmol, 25%).

**IR (neat)**: *ṽ* = 2931 (w), 1702 (s), 1601 (w), 1572 (w), 1489 (w), 1456 (w), 1439 (w), 1382 (w), 1296 (w), 1269 (w), 1229 (m), 1167 (w), 1081 (s), 1050 (w), 1036 (w), 963 (s), 819 (w), 757 (s), 719 (m), 658 (m), 576 (w), 459 (w). **¹H NMR (400 MHz, C₆D₆):** *δ* = 7.01 - 6.91 (m, 2H), 6.88 -6.78 (m, 2H), 4.65 (dd, *J* = 47.4, 1.1 Hz, 2H), 2.39 (s, 3H). **¹³C {¹H, ¹⁹F} NMR (101 MHz, C₆D₆):** *δ* = 196.4, 139.3, 134.3, 132.3, 132.0, 128.7, 125.6, 83.9, 21.1. **¹⁹F NMR (377 MHz, C₆D₆):** *δ* = -225.74 (t, *J* = 47.4 Hz, 1F). **HRMS (ESI)**: Calculated for C₉H₁₀FO [M+H]⁺: 153.0710, found: 153.0706. Spectroscopic data was in agreement to those previously reported.

### Example 2. 2,2-Difluoro-1-(o-tolyl)ethan-1-one [1c]

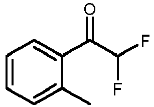

Mg-turnings (101 mg, 4.15 mmol, 2.15 eq.) were added to an oven-dried 25 mL Schlenk flask and dry THF (10.0 mL) was added. The mixture was cooled to 0 °C and TMS-Cl (902 mg, 650 µL, 8.30 mmol, 4.29 eq.) was added, followed by 2,2,2-trifluoro-1-(o-tolyl)ethan-1-one (364 mg, 1.93 mmol, 1.00 eq.). The mixture was stirred at 0 °C for 2 h and excess TMS-Cl and THF were removed *in vacuo via* a cooling trap. To the residue, hexane was added (20 mL) and the solids were removed *via* filtration. The solvent was removed under reduced pressure, HCl (5 M, 10 mL) was added and the mixture was stirred over-night. The mixture was extracted with Et₂O (3 × 20 mL) and the combined organic phases were washed with brine (3 × 20 mL), water (3 × 20 mL) and were dried over Na₂SO₄. The solvent was removed under reduced pressure and the crude product was purified *via* FC (pentane/Et₂O, 90:10) and bulb-to-bulb distillation (100 °C, 1.1 mbar) as a colorless oil (401 mg, 2.36 mmol, 40%).

**IR (neat):** *ṽ* = 2973 (w), 2360 (w), 2172 (w), 2148 (w), 2108 (w), 2060 (w), 2020 (w), 1982 (w), 1707 (s), 1602 (w), 1572 (w), 1491 (w), 1458 (w), 1384 (w), 1346 (w), 1296 (w), 1268 (w), 1236 (w), 1148 (m), 1123 (s), 1065 (s), 967 (w), 873 (w), 860 (w), 789 (w), 760 (w), 725 (m), 651 (w), 584 (w), 554 (w), 543 (w), 486 (w), 458 (w), 451 (w), 441 (w), 431 (w), 410 (w). **¹H NMR (400 MHz, C₆D₆):** *δ* = 7.50 (d, *J* = 7.7 Hz, 1H), 7.00 - 6.91 (m, 1H), 6.80 (d, *J* = 7.6 Hz, 2H), 5.65 (t, *J* = 53.7 Hz, 1H), 2.36 (s, 3H). **¹³C {¹H, ¹⁹F} NMR (101 MHz, C₆D₆):** *δ* = 189.5, 141.4, 133.1, 132.6, 131.5, 130.3, 125.8, 111.0, 21.6. **¹⁹F NMR (282 MHz, C₆D₆):** *δ* = - 122.31 (dd, *J* = 53.7, 1.9 Hz, 2F). **HRMS (APCI):** Calculated for C₉H₇F₂O [M-H]⁻: 169.0470, found: 169.0496.

### Example 3: 2,2,2-Trifluoro-1-(o-tolyl)ethan-1-one [1d]

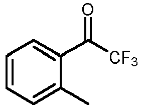

Following general procedure **A** using 2-bromotoluene (5.13 g, 3.61 mL, 30.0 mmol, 1.00 eq.), t-BuLi (3.92 g, 36.0 mL, 61.2 mmol, 1.70 M, 2.04 eq.) and ethyl trifluoroacetate (4.78 g, 4.00 mL, 33.7 mmol, 1.12 eq.) in Et₂O (150 mL). The desired product was obtained after FC (pentane) and bulb-to-bulb distillation (110 °C, 0.54 mbar) as a colorless oil (5.12 g, 27.2 mmol, 91%).

**IR (neat):** *ṽ* = 1715 (m), 1604 (w), 1573 (w), 1459 (w), 1385 (w), 1323 (w), 1288 (w), 1184 (s), 1142 (s), 1037 (w), 933 (s), 737 (s), 665 (m), 608 (w), 529 (w), 491 (w), 462 (w), 446 (w), 436 (w). **¹H NMR (400 MHz, C₆D₆):** *δ* = 7.62 (dq, *J* = 7.9, 1.9 Hz, 1H), 6.91 (td, *J* = 7.6, 1.4 Hz, 1H), 6.75 (t, *J* = 7.2 Hz, 2H), 2.28 (s, 3H). **¹³C NMR (101 MHz, C₆D₆):** *δ* = 182.2 (q, *J* = 33.7 Hz), 142.4, 133.8, 132.7, 130.5 (q, *J* = 3.7 Hz), 129.5, 126.0, 117.1 (q, *J* = 293.1 Hz), 21.7. **¹⁹F NMR (282 MHz, C₆D₆):** *δ* = -71.54 (d, *J* = 2.0 Hz, 3F). **HRMS (ESI):** Calculated for C₉H₆F₃O [M-H]⁻: 187.0376, found: 187.0381.

### Example 4: 1-(2-Ethylphenyl)-2,2,2-trifluoroethan-1-one [4]

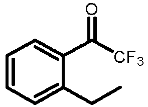

Following general procedure **A** using 1-ethyl-2-iodobenzene (1.16 g, 0.71 mL, 5.00 mmol, 1.00 eq.), *t*-BuLi (641 mg, 5.26 mL, 10.0 mmol, 1.90 M, 2.00 eq.) and ethyl trifluoroacetate (781 mg, 0.65 mL, 5.50 mmol, 1.10 eq.) in THF (20 mL). The desired product was obtained after FC (pentane) and bulb-to-bulb distillation (100 °C, 0.70 mbar) as a colorless oil (937 mg, 4.63 mmol, 93%).

**IR (neat):** *ṽ* = 2963 (w), 2932 (w), 2155 (w), 2034 (w), 2016 (w), 1720 (m), 1602 (w), 1573 (w), 1450 (w), 1323 (w), 1182 (s), 1144 (s), 934 (s), 790 (w), 754 (m), 734 (m), 662 (m), 635 (w), 607 (w), 586 (w), 564 (w), 556 (w), 540 (w), 528 (w), 518 (w), 507 (w), 498 (w), 482 (w), 468 (w), 459 (w), 449 (w), 429 (w), 418 (m). **¹H NMR (400 MHz, C₆D₆):** *δ* = 7.57 (dp, *J* = 7.7, 1.9 Hz, 1H), 6.97 (td, *J* = 7.6, 1.3 Hz, 1H), 6.84 (ddd, *J* = 7.8, 1.3, 0.6 Hz, 1H), 6.76 (td, *J* = 7.7, 1.3 Hz, 1H), 2.66 (q, *J* = 7.5 Hz, 2H), 1.04 (t, *J* = 7.5 Hz, 3H). **¹³C NMR (101 MHz, C₆D₆):** *δ* = 182.8 (q, *J* = 33.9 Hz), 148.0, 133.9, 131.1, 130.1, 129.6 (q, *J* = 3.6 Hz), 126.0, 117.2 (q, *J* = 293.2 Hz), 27.5, 15.6. **¹⁹F NMR (282 MHz, C₆D₆):** *δ* =-71.85 (d, *J* = 2.0 Hz). **HRMS (APCI):** Calculated for C₁₀H₉F₃O [M]^{.-}: 202.0610, found: 202.0613.

### Example 5: 2,2,2-Trifluoro-1-(2-isopropylphenyl)ethan-1-one [S1]

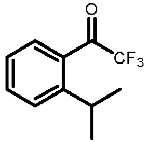

Following general procedure **A** using 1-iodo-2-isopropylbenzene (1.23 g, 0.79 mL, 5.00 mmol, 1.00 eq.), t-BuLi (641 mg, 5.88 mL, 10.0 mmol, 1.70 M, 2.00 eq.) and ethyl trifluoroacetate (781 mg, 0.65 mL, 5.50 mmol, 1.10 eq.) in THF (20 mL). The desired product was obtained after FC (pentane) as a colorless oil (589 mg, 2.72 mmol, 54%).

**IR (neat):** *ṽ* = 2960 (m), 2925 (m), 2871 (w), 2854 (w), 1721 (m), 1601 (w), 1463 (w), 1378 (w), 1365 (w), 1202 (s), 1182 (s), 1147 (s), 1035 (w), 936 (s), 758 (m), 728 (w), 660 (m), 624 (w), 610 (w), 600 (w), 573 (w), 565 (w), 540 (w), 530 (w), 515 (w), 506 (w), 490 (m), 462 (m), 444 (w), 433 (w), 417 (w). **¹H NMR (600 MHz,** CDCl₃): *δ* = 7.70 (dt, *J* = 8.0, 1.7 Hz, 1H), 7.61 - 7.56 (m, 1H), 7.55 - 7.51 (m, 1H), 7.34 - 7.30 (m, 1H), 3.40 (p, *J* = 6.8 Hz, 1H), 1.26 (d, *J* = 6.9 Hz, 6H). **¹³C NMR (151 MHz, CDCl₃):** *δ* = 184.3 (q, *J* = 34.5 Hz), 151.6, 133.8, 130.0, 128.9 (q, *J* = 292.9 Hz), 127.3, 125.7, 116.4 (q, *J* = 292.9 Hz), 29.7, 24.1. **¹⁹F NMR (282 MHz, C₆D₆):** *δ* = -72.77 (d, *J* = 1.8 Hz). **HRMS (APCI):** Calculated for C₁₁H₁₁F₃O [M]^{.-}: 216.0767, found: 216.0768.

### Example 6: 1-Bromo-2-(methoxymethyl)benzene [S2]

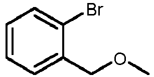

Sodium hydride (720 mg, 18.0 mmol, 1.20 eq.) was suspended in dry THF (100 mL) under inert gas atmosphere and a prepared solution of (2-bromophenyl)methanol (2.81 g, 15.0 mmol, 1.00 eq.) in dry THF (50 mL) was added dropwise at 0 °C. The mixture was stirred for 15 min and iodomethane (6.39 g, 2.80 mL, 45.0 mmol, 3.00 eq.) was added dropwise at 0 °C. The solution was stirred at 0 °C for 15 minutes and 16°h at rt.NH₄Cl sat. was added and the solution was diluted with CH₂Cl₂ (30 mL). The organic layer was separated, and the aqueous layer was extracted with CH₂Cl₂ (3 × 30 mL). The combined organic fractions were dried over Na₂SO₄ and the solvent was removed under reduced pressure. The product was obtained after FC (pentane/Et₂O, 100:0 to 80:20) as a slightly yellow oil (2.79 g, 13.9 mmol, 92%).**¹H NMR (400 MHz, CDCl₃):** *δ* = 7.54 (dd, *J* = 8.0, 1.3 Hz, 1H), 7.46 (ddd, *J* = 7.6, 1.8, 0.9 Hz, 1H), 7.32 (td, *J* = 7.5, 1.3 Hz, 1H), 7.20 -7.10 (m, 1H), 4.53 (s, 2H), 3.47 (s, 3H). **¹³C NMR (101 MHz, CDCl₃):** *δ* = 137.7, 132.7, 129.1, 129.0, 127.5, 122.8, 74.0, 58.8.

### Example 7: 2,2,2-Trifluoro-1-(2-(methoxymethyl)phenyl)ethan-1-one [S3]

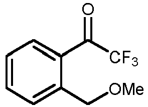

Following general procedure **A** using 1-bromo-2-(methoxymethyl)benzene (1.50 g, 7.46 mmol,1.00 eq.), *t*-BuLi (1.00 g, 9.22 mL, 15.7 mmol, 1.70 M, 2.10 eq.) and ethyl trifluoroacetate (1.27 g, 1.06 mL, 8.95 mmol, 1.20 eq.) in Et₂O (100 mL). The desired product was obtained after FC (pentane) as a colorless oil (1.04 g, 4.76 mmol, 64%).

**IR (neat):** *ṽ* = 2934 (w), 2830 (w), 1737 (w), 1713 (m), 1603 (w), 1574 (w), 1452 (w), 1383 (w), 1324 (w), 1292 (w), 1186 (s), 1143 (s), 1103 (m), 937 (s), 737 (m), 671 (w), 658 (w), 607 (w). **¹H NMR (400 MHz, C₆D₆):** *δ* = 7.50 (dt, *J* = 7.8, 1.6 Hz, 1H), 7.37 (dd, *J* = 7.8, 1.3 Hz, 1H), 7.03 (td, *J* = 7.7, 1.3 Hz, 1H), 6.80 (td, *J* = 7.7, 1.2 Hz, 1H), 4.42 (s, 2H), 3.03 (s, 3H). **¹³C NMR (101 MHz, C₆D₆):** *δ* = 183.5 (q, *J* = 34.8 Hz), 142.6, 133.4, 129.6 (q, *J* = 3.2 Hz), 129.3, 127.7, 127.2, 117.1 (q, *J* = 292.3 Hz), 72.4, 58.3. **¹⁹F NMR (377 MHz, C₆D₆):** *δ* = - 72.83 (d, *J* = 1.7 Hz). **HRMS (APCI):** Calculated for C₁₀H₈F₃O₂ [M-H]⁻: 217.0482, found 217.0464.

### Example 8: 2,2,2-Trifluoro-1-(4-methoxy-2-methylphenyl)ethan-1-one [S4]

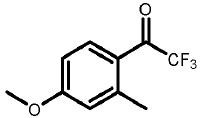

Following general procedure **A** using 4-bromo-3-methylanisole (3.12 g, 2.00 mL, 15.5 mmol,1.00 eq.), *t*-BuLi (1.99 g, 16.3 mL, 31.1 mmol, 1.90 M, 2.00 eq.) and ethyl trifluoroacetate (2.43 g, 2.03 mL, 17.1 mmol, 1.10 eq.) in Et₂O (100 mL). The desired product was obtained after FC (pentane) and bulb-to-bulb distillation (140 °C, 1.10 mbar) as a colorless oil (2.93 g, 13.4 mmol, 86%).

**¹H NMR (600 MHz,** CDCl₃): *δ* =7.91 (dq, *J* = 9.7, 1.7 Hz, 1H), 6.84 - 6.82 (m, 2H), 3.89 (s, 3H), 2.61 (s, 3H). **¹³C NMR (151 MHz, CDCl₃):** *δ* = 180.2 (q, *J* = 33.2 Hz), 164.0, 146.7, 134.0 (q, *J* = 4.2 Hz), 121.7, 118.4, 117.0 (q, *J* = 292.9 Hz), 111.2, 55.7, 23.1. **¹⁹F NMR (377 MHz, C₆D₆):** *δ* = -70.47 (d, *J* = 2.2 Hz, 3F).

### Example 9: 2,2,2-Trifluoro-1-(4-fluoro-2-methylphenyl)ethan-1-one [S5]

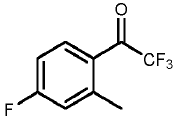

Following general procedure **A** using 4-fluoro-1-iodo-2-methylbenzene (3.54 g, 1.98 mL, 15.0 mmol, 1.00 eq.), *t*-BuLi (1.92 g, 15.8 mL, 30.0 mmol, 1.90 M, 2.00 eq.) and ethyl trifluoroacetate (2.34 g, 1.96 mL, 16.5 mmol, 1.10 eq.) in Et₂O (60 mL). The desired product was obtained after FC (pentane) and bulb-to-bulb distillation (60 °C, 0.80 mbar) as a colorless oil (2.18 g, 10.6 mmol, 70%).

**IR (neat):** *ṽ* = 2926 (w), 1716 (m), 1608 (m), 1581 (s), 1500 (w), 1453 (w), 1329 (w), 1300 (w), 1244 (m), 1204 (s), 1181 (s), 1142 (s), 1108 (s), 973 (s), 910 (m), 871 (w), 825 (w), 773 (m), 742 (w), 699 (w), 632 (m), 591 (w), 536 (w), 455 (w), 430 (w), 412 (w). **¹H NMR (400 MHz, CDCl₃):** *δ* = 7.94 (ddq, *J* = 9.7, 5.7, 1.9 Hz, 1H), 7.15 - 6.94 (m, 2H), 2.61 (s, 3H). **¹³C NMR (101 MHz, CDCl₃):** *δ* = 180.9 (q, *J* = 34.2 Hz), 165.7 (d, *J* = 258.5 Hz), 147.1 (d, *J* = 9.6 Hz), 134.2 - 133.2 (m), 125.6 (d, *J* = 3.0 Hz), 112.0 (d, *J* = 21.5 Hz), 116.6 (q, *J* = 292.7 Hz), 113.5 (d, *J =* 21.8 Hz), 22.44 (d, *J* = 1.5 Hz). **¹⁹F NMR (282 MHz, C₆D₆):** *δ* = -71.37 (d, *J* = 1.9 Hz, 3F), -103.20 (td, *J* = 8.7, 5.7 Hz, 1F). **HRMS (ESI):** Calculated for **C₉H₅F₄O** [M-H]⁻: 205.0282, found: 205.0288.

### Example 10: 1-(4-Chloro-2-methylphenyl)-2,2,2-trifluoroethan-1-one [S6]

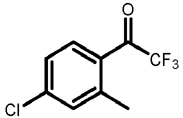

Following general procedure **A** using 2-bromo-5-chlorotoluene (3.08 g, 2.00 mL, 15.0 mmol, 1.00 eq.), *t*-BuLi (1.92 g, 15.8 mL, 30.0 mmol, 1.90 M, 2.00 eq.) and ethyl trifluoroacetate (2.34 g, 1.96 mL, 16.5 mmol, 1.10 eq.) in Et₂O (100 mL). The desired product was obtained after FC (pentane) and bulb-to-bulb distillation (90 °C, 1.1 mbar) as a colorless oil (2.90 g, 13.0 mmol, 87%).

**IR (neat):** *ṽ* = 2983 (w), 2236 (w), 1725 (m), 1608 (w), 1558 (w), 1451 (w), 1386 (w), 1326 (w), 1281 (w), 1206 (m), 1186 (s), 1146 (s), 1038 (w), 958 (s), 894 (m), 838 (w), 775 (w), 742 (w), 713 (w), 631 (w), 587 (w), 558 (w), 525 (w), 450 (w). **¹H NMR (400 MHz, C₆D₆):** *δ* = 7.10 (dq, *J* = 8.2, 1.9 Hz, 1H), 6.63 (dd, *J* = 8.2, 1.7 Hz, 1H), 6.55 (d, *J* = 1.7 Hz, 1H), 1.89 (s, 3H). **¹³C NMR (101 MHz, C₆D₆):** *δ* = 181.9 (q, *J* = 35.0 Hz), 142.2, 135.4, 132.3, 129.8 (q, *J* = 3.6 Hz), 129.2, 117.4, 117.2, 116.5 (q, *J* = 292.6 Hz), 20.7. **¹⁹F NMR (377 MHz, C₆D₆):** *δ* = -71.64 (d, *J* = 2.0 Hz, 3F). **HRMS (ESI):** Calculated for C₉H₅ClF₃O [M-H]⁻: 220.9986, found: 220.9986.

### Example 11: 1-(4-Chloro-2-ethylphenyl)-2,2,2-trifluoroethan-1-one [S7]

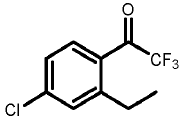

Following general procedure **A** using 1-bromo-4-chloro-2-ethylbenzene (409 mg, 0.27 mL, 1.86 mmol, 1.00 eq.), *t*-BuLi (239 mg, 2.19 mL, 3.73 mmol, 1.70 M, 2.00 eq.) and ethyl trifluoroacetate (318 mg, 0.27 mL, 2.24 mmol, 1.20 eq.) in Et₂O (25 mL). The desired product was obtained after FC (pentane) and bulb-to-bulb distillation (110 °C, 1.1 mbar) as a colorless oil (299 mg, 1.26 mmol, 68%).

**IR (neat):** *ṽ* = 2977 (w), 2880 (w), 1718 (m), 1593 (m), 1559 (w), 1458 (w), 1396 (w), 1323 (w), 1289 (w), 1237 (w), 1195 (s), 1182 (s), 1145 (s), 1106 (m), 1061 (w), 975 (w), 935 (s), 885 (w), 843 (w), 828 (w), 776 (w), 740 (w), 688 (w), 619 (w), 531 (w), 499 (w), 469 (w). **¹H NMR (400 MHz, C₆D₆):** *δ* = 7.27 (dq, *J* = 8.5, 1.9 Hz, 0H), 6.87 (d, *J* = 2.1 Hz, 0H), 6.70 (dd, *J* = 8.5, 2.2 Hz, 1H), 2.47 (q, *J* = 7.5 Hz, 1H), 0.88 (t, *J* = 7.5 Hz, 2H). **¹³C NMR (101 MHz, C₆D₆):** *δ* = 181.7 (q, *J* = 34.3 Hz), 150.2, 140.5, 131.5 (q, *J* = 3.8 Hz), 131.3, 127.6, 126.3, 116.9 (q, *J* = 293.1 Hz), 27.3, 15.1. **¹⁹F NMR (377 MHz, C₆D₆):** *δ* = -71.92 (d, *J* = 2.0 Hz, 3F). **HRMS (ESI):** Calculated for C₁₀H₇ClF₃O [M-H]⁻: 235.0143, found: 235.0149.

### Example 12: 3-Methyl-4-(2,2,2-trifluoroacetyl)benzonitrile [S8]

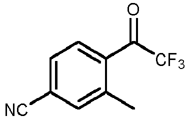

Following general procedure A using 4-bromo-3-methylbenzonitrile (1.01 g, 5.14 mmol,1.00 eq.), t-BuLi (658 mg, 5.41 mL, 10.3 mmol, 1.90 M, 2.00 eq.) and ethyl trifluoroacetate (803 mg, 0.67 mL, 5.65 mmol, 1.20 eq.) in a mixture of Et₂O (20 mL) and THF (5 mL). The desired product was obtained after FC (pentane) and bulb-to-bulb distillation (140 °C, 1.1 mbar) as a colorless solid (576 mg, 2.70 mmol, 53%).

**M.P.:** 40 - 45 °C. **IR (neat):** *ṽ* = 2236 (w), 1725 (s), 1607 (w), 1558 (w), 1450 (w), 1386 (w), 1326 (w), 1281 (w), 1206 (m), 1185 (s), 1144 (s), 1038 (w), 958 (s), 894 (s), 838 (w), 775 (m), 742 (m), 713 (w), 630 (w), 588 (w), 559 (w), 524 (w), 450 (w). **¹H NMR (400 MHz, C₆D₆):** *δ* = 7.08 (dq, *J* = 8.3, 1.8 Hz, 1H), 6.61 (dd, *J* = 8.2, 1.6 Hz, 1H), 6.54 (t, *J* = 1.1 Hz, 1H), 1.88 (s, 3H). **¹³C NMR (101 MHz, C₆D₆):** *δ* = 181.9 (q, *J* = 35.1 Hz), 142.2, 135.4, 132.3, 129.7 (q, *J* = 3.6 Hz), 129.2, 117.4, 117.2, 116.5 (q, *J* = 292.7 Hz), 20.7. **¹⁹F NMR (282 MHz, C₆D₆):** *δ* =-72.57 (d, *J* = 1.8 Hz, 3F). **HRMS (ESI):** Calculated for C₁₀H₅F₃NO [M-H]⁻: 212.0329, found 212.0336.

### B) Photocyclization of Substrates

General procedure **B** for the synthesis of tertiary cyclobutanols from ortho-alkyl-substituted acetophenones:
An ortho-alkyl-substituted acetophenone was dissolved in benzene (20 mM), degassed (3 × freeze-pump-thaw) and was irradiated using a Luzchem Photoreactor equipped with 10 8 Watt LZC-UVA (355 nm) lamps for 16 h at rt. The solvent was removed under reduced pressure and desired product was isolated after automated FC (pentane/Et₂O, 100:0 to 50:50; exact gradient: 4 column volumes (CV) 100:0, 4 CV 100:0 to 90:10, 4 CV 90:10, 4 CV 80:20, 4 CV 70:30, 4 CV 50:50).

General procedure **C** for the synthesis of tertiary cyclobutanols from ortho-alkyl-substituted acetophenones:
An ortho-alkyl-substituted acetophenone was dissolved in benzene (20 mM), degassed (3 × freeze-pump-thaw) and was irradiated using a 40 W 370 nm Gen 2 KSPR160L Kessil LED at rt. The solvent was removed under reduced pressure and desired product was isolated after FC, automated FC, or RP-MPLC.

### Example 13: 7-Methylbicyclo[4.2.0]octa-1,3,5-trien-7-ol [3a]

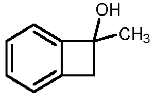

Following general procedure **B** with minor alterations using 1-(o-Tolyl)ethan-1-one (262 µL, 2.00 mmol, 1.00 eq.) in acetonitrile (100 mL) for 17 h. The solution was degassed by passing through a stream of N₂ for 15 min before irradiation. After automated FC (CyH/EtOAc, 90:10 to 80:20), the starting material (224 mg, 218 µL, 1.67 mmol, 83%) and product (43.0 mg, 320 µmol, 16%) were isolated.

**¹H NMR (400 MHz, CDCl₃):** *δ* = 7.31 - 7.26 (m, 1H), 7.23 (tq, *J* = 7.6, 0.9 Hz, 1H), 7.19 - 7.14 (m, 2H), 3.39 - 3.30 (m, 1H), 3.22 (d, *J* = 14.1 Hz, 1H), 2.47 (s, 1H) 1.66 (s, 3H). **¹³C NMR (101 MHz, CDCl₃):** *δ* = 151.2, 141.3, 129.4, 127.4, 124.2, 120.6, 78.4, 48.4, 25.8.

### Example 14: 7-(Fluoromethyl)bicyclo[4.2.0]octa-1,3,5-trien-7-ol [3b]

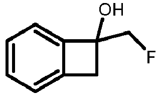

Following general procedure **C** with minor alterations using 2-fluoro-1-(o-tolyl)ethan-1-one (112 mg, 0.74 mmol) in acetonitrile (50 mL) for 6 h. The desired product was obtained after FC (pentane/Et₂O, 80:20) and bulb-to-bulb distillation (150 °C, 1.1 mbar) as a colorless oil (14 mg, 0.09 mmol, 12%).

**IR (neat):** *ṽ* = 3551 (w), 3387 (m), 3346 (m), 3069 (w), 2928 (m), 1459 (m), 1423 (w), 1364 (m), 1331 (w), 1266 (m), 1201 (s), 1155 (m), 1111 (m), 1067 (m), 1044 (m), 1018 (s), 994 (s), 966 (m), 918 (m), 758 (s), 734 (s), 715 (s), 644 (m), 601 (w), 583 (w), 572 (w), 541 (w), 478 (w), 422 (w), 415 (w). **¹H NMR (400 MHz, C₆D₆):** *δ* = 7.08 (td, *J* = 7.2, 1.6 Hz, 1H), 7.05 - 6.97 (m, 2H), 6.88 (dt, *J* = 7.3, 1.0 Hz, 1H), 4.33 - 4.24 (m, 1H), 4.21 - 4.10 (m, 1H), 2.99 (d, *J* = 14.2 Hz, 1H), 2.82 (dd, *J* = 14.2, 3.3 Hz, 1H), 2.03 (s, 1H). **¹³C NMR (101 MHz,** C₆D₆): *δ* = 147.2 (d, *J* = 7.4 Hz), 141.7, 130.0, 127.6, 123.9, 122.0, 87.3 (d, *J* = 174.7 Hz), 78.7 (d, *J* = 19.4 Hz), 42.9 (d, *J* = 6.5 Hz). **¹⁹F NMR (377 MHz, C₆D₆):** *δ* = -225.74 (t, *J* = 47.2 Hz, 1F). **HRMS (ESI):** Calculated for C₉H₈FO [M-H]⁻: 151.0565, found: 151.0526.

### Example 15: 7-(Difluoromethyl)bicyclo[4.2.0]octa-1,3,5-trien-7-ol [3c]

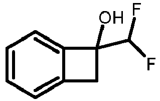

Following general procedure **B** with minor alterations using 2,2-difluoro-1-(o-tolyl)ethan-1-one (21.4 mg, 0.126 mmol) in benzene (6 mL, 20 mM). The product was obtained after automated FC (pentane/Et₂O, 100:0 to 50:50) as a colorless oil (13.0 mg, 0.076 mmol, 61%).

**IR (neat):** *ṽ* = 3363 (w), 2935 (w), 1460 (w), 1425 (w), 1347 (w), 1277 (w), 1239 (m), 1192 (w), 1157 (w), 1113 (m), 1094 (m), 1062 (s), 982 (w), 952 (w), 889 (w), 818 (w), 758 (m), 735 (w), 715 (w), 673 (w), 657 (w), 621 (w), 567 (w), 552 (w), 516 (w), 464 (w), 449 (w), 414 (w). **¹H NMR (400 MHz, C₆D₆):** *δ* =7.10 - 6.91 (m, 3H), 6.82 (d, *J* = 7.3 Hz, 1H), 5.42 (t, *J* = 54.8 Hz, 1H), 3.19 (dd, *J* = 14.4, 2.4 Hz, 1H), 2.73 (d, *J* = 14.3 Hz, 1H), 1.98 (s, 1H). **¹³C {¹H, ¹⁹F} NMR (101 MHz, C₆D₆):** *δ* = 143.7, 142.1, 130.6, 127.9, 123.6, 122.5, 115.9, 78.8, 41.3. **¹⁹F NMR (377 MHz, C₆D₆):** *δ* = -126.79 - -132.30 (m, 2F). **HRMS (ESI):** Calculated for C₉H₇F₂O [M-H]⁻: 169.0470, found: 169.0475.

### Example 17: 7-(Trifluoromethyl)bicyclo[4.2.0]octa-1,3,5-trien-7-ol [3d]

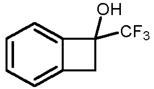

Following general procedure **B** using 2,2,2-trifluoro-1-(o-tolyl)ethan-1-one (23 mg, 0.122 mmol) in benzene (6 mL, 20 mM). The product was obtained after automated FC (pentane/Et₂O, 100:0 to 50:50) as a colorless solid (16 mg, 0.085 mmol, 70%).

**M.P.:** 39 - 44 °C. **IR (neat):** *ṽ* = 3349 (w), 2942 (w), 1595 (w), 1461 (w), 1428 (w), 1311 (w), 1232 (w), 1153 (s), 1128 (s), 1095 (m), 1069 (m), 1018 (m), 955 (w), 863 (w), 757 (m), 743 (w), 715 (m), 662 (m), 629 (w), 597 (w), 556 (w), 509 (w), 460 (w). **¹H NMR (400 MHz, C₆D₆):** *δ* = 7.02 (td, *J* = 7.4, 1.3 Hz, 1H), 6.99 - 6.90 (m, 2H), 6.82 - 6.73 (m, 1H), 3.40 (d, *J* = 14.4, 1H), 2.75 (d, *J* = 14.4, 1H), 2.23 (s, 1H). **¹³C NMR (101 MHz, C₆D₆):** *δ* = 142.2, 142.0 (q, *J* = 1.9 Hz), 131.1, 128.2, 125.5(q, *J* = 281.7 Hz), 123.7, 122.2, 78.3 (q, *J* = 32.8 Hz), 41.8 (q, *J* = 2.0 Hz). **¹⁹F NMR (282 MHz, C₆D₆):** *δ* = -81.1 (s, 3F). **HRMS (ESI):** Calculated for C₉H₆F₃O [M-H]-: 187.0376, found: 187.0373.

### Example 18: 8-Methyl-7-(trifluoromethyl)bicyclo[4.2.0]octa-1,3,5-trien-7-ol [6]

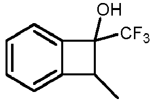

Following general procedure **B** using 1-(2-ethylphenyl)-2,2,2-trifluoroethan-1-one (24 mg, 0.12 mmol) in benzene (6 mL, 20 mM). The product was obtained after automated FC (pentane/Et₂O, 100:0 to 50:50) as a colorless oil (14 mg, 0.07 mmol, 58%).

**M.P.:** 30.0 - 38.5 °C. **IR (neat):** *ṽ* = 3345 (w), 1458 (w), 1343 (w), 1284 (w), 1228 (w), 1148 (s), 1107 (s), 1083 (m), 1051 (m), 951 (m), 935 (m), 894 (w), 757 (m), 744 (m), 662 (m), 640 (w), 593 (w), 532 (w), 471 (w), 453 (w), 434 (w). **¹H NMR (400 MHz, C₆D₆):** *δ* = 7.05 (td, *J* = 7.4, 1.3 Hz, 1H), 7.02 - 6.99 (m, 1H), 6.98 - 6.93 (m, 1H), 6.81 (dq, *J* = 7.4, 1.0 Hz, 1H), 3.32 (dddd, *J* = 8.5, 7.4, 6.3, 1.1 Hz, 1H), 2.17 (s, 1H), 1.30 (dq, *J* = 7.4, 1.7 Hz, 3H). **¹³C NMR (101 MHz, C₆D₆):** *δ* = 147.2, 140.4 (q, *J* = 2.4 Hz), 131.2, 128.4, 125.6 (q, *J* = 282.7 Hz), 122.2, 122.2, 80.6 (q, *J* = 30.8 Hz), 52.2, 13.5 (q, *J* = 2.3 Hz). **¹⁹F NMR (377 MHz, C₆D₆):** *δ* = -75.8 (s, 3F). **HRMS (ESI):** Calculated for C₁₀H₈F₃O [M-H]⁻: 201.0533, found: 201.0535.

### Example 19: 8-Methoxy-7-(trifluoromethyl)bicyclo[4.2.0]octa-1,3,5-trien-7-ol [S9]

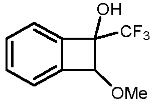

Following general procedure **B** using 2,2,2-trifluoro-1-(2-(methoxymethyl)phenyl)ethan-1-one (26.5 mg, 0.122 mmol) in benzene (6 mL, 20 mM). The product was obtained after automated FC (pentane/Et₂O, 100:0 to 50:50) as a colorless oil (18.0 mg, 0.083 mmol, 68%).

**M.P.:** 40.0 - 46.5 °C. **IR (neat):** *ṽ* = 3389 (w), 2942 (w), 2841 (w), 1463 (w), 1361 (m), 1298 (m), 1208 (m), 1177 (s), 1151 (s), 1115 (s), 1063 (s), 1013 (w), 986 (m), 905 (m), 802 (w), 760 (m), 736 (m), 685 (w), 660 (m), 624 (w), 592 (w), 519 (w), 468 (w). **¹H NMR (400 MHz, C₆D₆):** *δ* = 7.08 - 6.93 (m, 4H), 4.52 (s, 1H), 3.29 (s, 3H), 2.31 (br s, 1H). **¹³C NMR (101 MHz, C₆D₆):** *δ* = 143.9, 138.9 (q, *J* = 2.4 Hz), 131.4, 130.4, 125.28 (q, *J* = 280.6 Hz), 123.7, 122.8, 88.4, 82.9 (q, *J* = 30.6 Hz), 58.7. **¹⁹F NMR (282 MHz, C₆D₆):** *δ* = -75.7 (s, 3F). **HRMS (APCI):** Calculated for C₁₀H₈F₃O₂ [M-H]⁻: 217.0482, found: 217.0452.

### Example 20: 3-Methoxy-7-(trifluoromethyl)bicyclo[4.2.0]octa-1,3,5-trien-7-ol [S10]

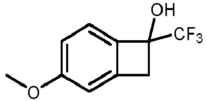

Following general procedure **B** using 2,2,2-trifluoro-1-(4-methoxy-2-methylphenyl)ethan-1-one (27.2mg, 0.125 mmol) in benzene (6 mL, 20 mM). The product was obtained after automated FC (pentane/Et₂O, 100:0 to 50:50) as a colorless oil (4.0 mg, 0.018 mmol, 15%).

**IR (neat):** *ṽ* = 3413 (w), 2943 (w), 1605 (w), 1481 (m), 1314 (w), 1275 (m), 1257 (m), 1238 (m), 1162 (s), 1127 (s), 1090 (s), 1017 (m), 955 (w), 822 (w), 733 (w), 602 (w), 589 (w), 549 (w), 503 (w), 473 (w), 464 (w), 453 (w), 426 (w), 413 (w). **¹H NMR (400 MHz, C₆D₆):** *δ* = 6.90 (d, *J* = 8.2 Hz, 1H), 6.62 (dd, *J* = 8.3, 2.1 Hz, 1H), 6.46 - 6.32 (m, 1H), 3.38 (d, *J* = 14.3 Hz, 1H), 3.21 (s, 3H), 2.75 (d, *J* = 14.3 Hz, 1H), 2.10 (s, 1H). **¹³C NMR (101 MHz, C₆D₆):** *δ* = 162.7, 143.3, 133.6, 125.7 (q, *J* = 281.6 Hz), 123.6, 115.4, 108.9, 77.6 (q, *J* = 32.8 Hz), 55.0, 41.4 (q, *J* = 2.4 Hz). **¹⁹F NMR (282 MHz, C₆D₆):** *δ* = -81.1 (s, 3F). **HRMS (ESI):** Calculated for C₁₀H₈F₃O₃ [M-H]⁻: 217.0482, found: 217.0486.

### Example 21: 3-Fluoro-7-(trifluoromethyl)bicyclo[4.2.0]octa-1,3,5-trien-7-ol [S11]

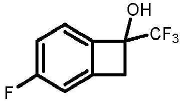

Following general procedure **B** using 2,2,2-trifluoro-1-(4-fluoro-2-methylphenyl)ethan-1-one (24.8mg, 0.12 mmol) in benzene (6 mL, 20 mM). The product was obtained after automated FC (pentane/Et₂O, 100:0 to 50:50) as a colorless oil (16 mg, 0.078 mmol, 65%).

**IR (neat):** *ṽ* = 3375 (w), 2946 (w), 1598 (w), 1471 (m), 1427 (w), 1311 (m), 1243 (m), 1158 (s), 1127 (s), 1083 (s), 1018 (m), 960 (m), 899 (w), 879 (w), 849 (m), 820 (m), 787 (w), 734 (w), 650 (w), 597 (m), 580 (m), 541 (w), 511 (w), 469 (w), 412 (w). **¹H NMR (400 MHz,** C₆D₆): *δ* = 6.71 (dd, *J* = 8.2, 4.6 Hz, 1H), 6.59 (ddd, *J* = 10.5, 8.2, 2.4 Hz, 1H), 6.42 (dd, *J* = 7.7, 2.1 Hz, 1H), 3.19 (d, *J* = 14.6 Hz, 1H), 2.56 (dt, *J* = 14.7, 1.2 Hz, 1H), 2.03 (s, 1H). **¹³C NMR (101 MHz, C₆D₆):** *δ* = 165.0 (d, *J* = 248.6 Hz), 143.8 (d, *J* = 8.6 Hz), 137.3 - 137.2 (m), 125.3 (q, *J* = 281.8 Hz), 124.4 (d, *J* = 9.4 Hz), 116.0 (d, *J* = 24.3 Hz), 111.56 (d, *J* = 23.1 Hz), 77.3 (q, *J* = 32.9 Hz), 41.4 - 41.1 (m) **¹⁹F NMR (282 MHz, C₆D₆):** δ = -81.27 (s, 3F), -107.45 - -107.55 (m, 1F). **HRMS (APCI):** Calculated for C₉H₅F₄O [M-H]⁻: 205.0282, found: 205.0281.

### Example 22: 3-Chloro-7-(trifluoromethyl)bicyclo[4.2.0]octa-1,3,5-trien-7-ol [S12]

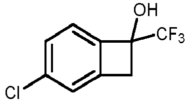

Following general procedure **B** using 1-(4-chloro-2-methylphenyl)-2,2,2-trifluoroethan-1-one (22.7mg, 0.10 mmol) in benzene (6 mL, 20 mM). The product was obtained after automated FC (pentane/Et₂O, 100:0 to 50:50) as a colorless solid (12 mg, 0.054 mmol, 53%).

**M.P.:** 70 - 77 °C. **IR (neat):** *ṽ* = 3361 (w), 2945 (w), 1591 (w), 1458 (w), 1426 (w), 1301 (m), 1230 (w), 1167 (s), 1134 (m), 1104 (w), 1072 (m), 1049 (w), 1020 (m), 954 (w), 854 (w), 819 (m), 758 (w), 715 (w), 595 (w), 505 (w), 424 (w). **¹H NMR (400 MHz,** C₆D₆): *δ* = 6.90 (ddt, *J* = 7.9, 1.7, 0.9 Hz, 1H), 6.72 - 6.69 (m, 1H), 6.63 (d, *J* = 7.9 Hz, 1H), 3.18 (dt, *J* = 14.7, 0.9 Hz, 1H), 2.54 (dd, *J* = 14.7, 1.1 Hz, 1H), 2.00 (s, 1H). **¹³C NMR (101 MHz,** C₆D₆): *δ* = 143.5, 140.0, 140.0 (q, *J* = 1.9 Hz), 137.0, 128.9, 125.2 (q, *J* = 281.7 Hz), 124.4, 123.7, 77.6 (q, *J* = 32.9 Hz), 41.5 (q, *J* = 1.9 Hz). **¹⁹F NMR (282 MHz, C₆D₆):** *δ* = -81.20 (s, 3F). **HRMS (ESI):** Calculated for C₉H₅ClF₃O [M-H]-: 220.9995, found: 220.9987.

### Example 23: 3-Chloro-8-methyl-7-(trifluoromethyl)bicyclo[4.2.0]octa-1,3,5-trien-7-ol [S13]

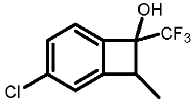

Following general procedure **B** with minor alterations using 1-(4-chloro-2-ethylphenyl)-2,2,2-trifluoroethan-1-one (78 mg, 0.33 mmol) in benzene (16.5 mL, 20 mM). The product was obtained after automated FC (pentane/Et₂O, 100:0 to 50:50) as a colorless solid (66 mg, 0.28 mmol, 85%) and a sample suitable for X-ray analysis was obtained.

**M.P.:** 44.4 - 53.5 °C. **IR (neat):** *ṽ* = 3359 (w), 2995 (w), 2941 (w), 2884 (w), 1588 (w), 1455 (w), 1414 (w), 1339 (w), 1279 (m), 1248 (w), 1227 (w), 1162 (s), 1112 (s), 1081 (w), 1057 (s), 1013 (w), 942 (m), 896 (w), 876 (w), 820 (m), 757 (w), 740 (w), 709 (w), 653 (w), 597 (w), 535 (w), 505 (w), 454 (w), 433 (w). **¹H NMR (400 MHz, C₆D₆):** *δ* = 6.93 (dt, *J* = 7.8, 1.3 Hz, 1H), 6.75 (q, *J* = 1.1 Hz, 1H), 6.67 (d, *J* = 7.9 Hz, 1H), 3.30 - 3.02 (m, 1H), 2.01 (d, *J* = 2.4 Hz, 1H), 1.16 (dq, *J* = 7.4, 1.7 Hz, 3H). **¹³C NMR (101 MHz, C₆D₆):** *δ* = 148.4, 138.4 (q, *J* = 2.3 Hz), 137.0, 129.1, 125.2 (q, *J* = 283.5 Hz), 123.8, 123.1, 79.9 (q, *J* = 31.1 Hz), 52.0, 13.1 (q, *J* = 2.3 Hz). **¹⁹F NMR (282 MHz, C₆D₆):** *δ* = -75.94 (s, 3F). **HRMS (ESI):** Calculated for C₁₀H₇ClF₃O [M-H]⁻: 235.0143, found: 235.0152.

### Example 24: 7-Hydroxy-7-(trifluoromethyl)bicyclo[4.2.0]octa-1,3,5-triene-3-carbonitrile [S14]

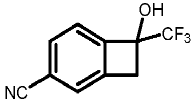

Following general procedure **B** with minor alterations using 3-methyl-4-(2,2,2-trifluoroacetyl)benzonitrile (25.6 mg, 0.12 mmol) in benzene (6 mL, 20 mM). The product was obtained after automated FC (pentane/Et₂O, 100:0 to 50:50) as a colorless solid (11.0 mg, 0.052 mmol, 43%).

**M.P.:** 142.0 - 146.5 °C. **IR (neat):** *ṽ* = 3384 (w), 2235 (w), 1427 (w), 1305 (w), 1239 (w), 1166 (s), 1144 (s), 1121 (w), 1092 (w), 1073 (w), 1019 (w), 959 (w), 831 (w), 727 (w), 654 (w), 604 (w), 536 (w), 506 (w), 465 (w), 431 (w). **¹H NMR (400 MHz, C₆D₆):** *δ* = 6.78 (dd, *J* = 7.8, 1.2 Hz, 1H), 6.54 (d, *J* = 7.7 Hz, 1H), 6.53 - 6.49 (m, 1H), 3.08 (d, *J* = 14.9 Hz, 1H), 2.46 (d, *J* = 14.9 Hz, 1H), 2.12 (s, 1H). **¹³C NMR (101 MHz, C₆D₆):** *δ* = 145.9 - 145.8 (m), 142.7, 132.3, 127.2, 124.8 (q, *J =* 281.9 Hz), 122.8, 118.5, 115.1, 78.0 (d, *J =* 33.2 Hz), 41.4 (q, *J* = 2.0 Hz). **¹⁹F NMR (282 MHz, C₆D₆):** *δ* = -81.11 (s, 3F). **HRMS (ESI):** Calculated for C₁₀H₅F₃NO [M-H]⁻: 212.0329, found 212.0336.

### C) Effect of Substituents on Reactivity

In order to assess the effect of different substituents on the photocyclization of **1** to **3,** reactions were stopped at a specific time point with incomplete conversion. Samples were prepared using general procedure **B** in degassed C₆D₆ (20 mM). After sample preparation, an internal standard was added, and the concentration verified by ¹H and ¹⁹F NMR analysis. All samples were irradiated for exactly 3 h in a single experiment using a Luzchem Photoreactor equipped with 10 8 Watt LZC-UVA (355 nm) lamps equipped with a sample carousel. This ensures that all reactions are run under identical conditions and can be accurately compared. The experiments were in triplicates whereas yield and conversion were determined by ¹H NMR (mesitylene) or ¹⁹F NMR (PhCF₃) and are given as mean values with standard deviation. The data is summarized in Table 2.

**Table 2: Comparison of substrate reactivity.**

| 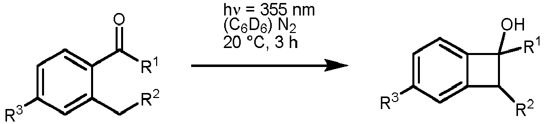 | | | | | |
|---|---|---|---|---|---|
| Entry | Substrate | | Internal standard | Conversion (%) | Yield (%) |
| 1 | R¹ = CH₃ | 1a | mesitylene | 16.9 | ~1 |
| | R² = H | | | | |
| | R³ = H | | | | |
| 2 | R¹ = CH₂F | 1b | mesitylene | 7.7 ± 0.7 | ~1 |
| | R² = H | | | | |
| | R³ = H | | | | |
| 3 | R¹ = CHF₂ | 1c | mesitylene | 55.2 ± 1.3 | 47.5 ± 0.6 |
| | R² = H | | | | |
| | R³ = H | | | | |
| 4 | R¹ = CF₃ | 1d | PhCF₃ | 66.0 ± 0.4 | 66.0 ± 0.4 |
| | R² = H | | | | |
| | R³ = H | | | | |
| 5 | R¹ = CF₃ | 4 | PhCF₃ | 33.0 ± 0.3 | 27.4 ± 0.1 |
| | R² = CH₃ | | | | |
| | R³ = H | | | | |
| 6 | R¹ = CF₃ | S1 | PhCF₃ | 8.0 ± 1.75 | 0 |
| | R² = (CH₃)₂ | | | | |
| | R³ = H | | | | |
| 7 | R¹ = CF₃ | S3 | PhCF₃ | 37.2 ± 0.8 | 29.9 ± 1.9 |
| | R² = OCH₃ | | | | |
| | R³ = H | | | | |
| 8 | R¹ = CF₃ | S4 | PhCF₃ | 90.9 ± 1.4 | 63.0 ± 0.5 |
| | R² = H | | | | |
| | R³ = OCH₃ | | | | |
| 8 | R¹ = CF₃ | S5 | PhCF₃ | 68.7 ± 0.2 | 59.6 ± 0.4 |
| | R² = H | | | | |
| | R³ = F | | | | |
| 9 | R¹ = CF₃ | S6 | PhCF₃ | 79.3 ± 0.7 | 73.9 ± 0.7 |
| | R² = H | | | | |
| | R³ = Cl | | | | |
| 10 | R¹ = CF₃ | S7 | PhCF₃ | 41.2 ± 0.8 | 36.3 ± 0.3 |
| | R² = CH₃ | | | | |
| | R³ = Cl | | | | |
| 11 | R¹ = CF₃ | S8 | PhCF₃ | 48.4 ± 4.5 | 42.2 ± 3.1 |
| | R² = H | | | | |
| | R³ = CN | | | | |

| | | | | | |
|---|---|---|---|---|---|
| Yields determined using ¹H (mesitylene) or ¹⁹F NMR (PhCF₃). Conversion and yield are stated as mean values of three experiments. | | | | | |

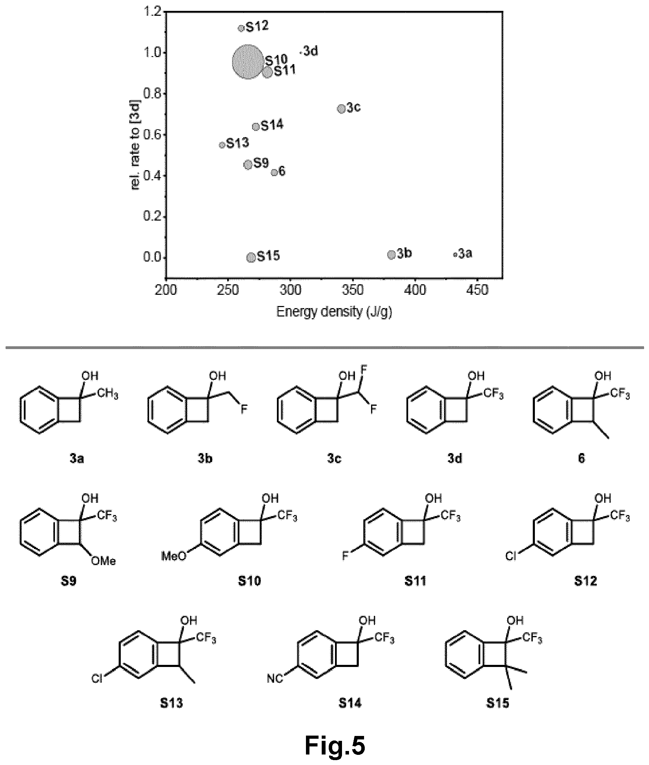

The data from Table 2 is visualized in Fig.5 in a bubble diagram. The conversion of **1d** to **3d** was taken as a reference and reaction rates were calculated relative to this transformation. The energy density of **3d** (58 kJ/mol) was used as a rough estimation to calculate the energy densities of all substituted compounds. While this probably is a good measure for para-substituted examples and for H/F displacements, we are aware that all changes in the molecular structure can result in a different energetic property of the molecule and hence can lead to variations in the absolute values of the energy density of the substance. This holds especially true for all variations on the cyclobutanol core (*e*.*g*. ortho-Et, iPr substitution). However, these substitutions were found to lead to poor reaction rates and are therefore still included in the graphical representation (see Fig 5).

### D) Optimization of reaction conditions

### D1) Solvent screening

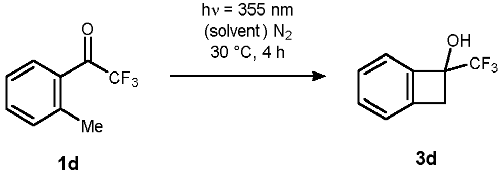

**Table 3: Solvent screening for the conversion of 1d to 3d.**

| Entry | Solvent | Yield **3d** / % |
|---|---|---|
| 1 | MeCN | 32^{a} |
| 2 | MeOH | 5 |
| 3 | EtOAc | 70^{a} |
| 4 | hexane | 34^{b} |
| 5 | CyH | 41^{b} |
| 6 | benzene | 45 |

| | | |
|---|---|---|
| Reactions run on 0.05 mmol scale in degassed solvent (20 mM) under inert gas atmosphere. After the reaction, solvent was removed under reduced pressure and residue dissolved in CDCl₃. Yields determined using ¹H NMR with mesitylene as internal standard. ^{a}Several signals detected in ¹⁹F NMR. ^{b}Oxygen side product observed. | | |

Benzene was selected as the ideal solvent for the transformation because no side products were detected in ¹⁹F and ¹H NMR. Additionally, the solvent was easily removable under reduced pressure. Solvents with higher boiling points like toluene or PhCF₃, although performing comparably well during the photocyclization, were excluded due to severe material loss during solvent evaporation.

### D2) Oxygen sensitivity

The reaction of **1d** to **3d** is very sensitive to oxygen and peroxide **8d** is formed alongside **3d** when running the reaction under aerobic conditions. **8d** can be isolated *via* column chromatography as a white solid, which was found to be stable over an extended period of time when kept at -20 °C. However, **8d** was found to slowly decompose in solution to form hemiacetals **9d,** which are insoluble in benzene and crush out of the solution.

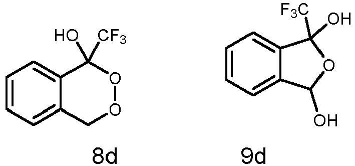

### D3) Scale-up

The scalability of the reaction was accessed by running the reaction on a 4.7 mmol scale:
Following general procedure **B** with minor alterations using 2,2,2-trifluoro-1-(o-tolyl)ethan-1-one (889 mg, 4.73 mmol) in benzene (10 mL, 473 mM) for 90 h. The product was obtained after automated FC (pentane/Et₂O, 70:30) as a colorless solid (872 mg, 4.63 mmol, 98%).

To decrease the reaction time, we switched to using a *Kessil* 45W PR160L 370nm Gen2 LED and were able to decrease the reaction time to 10 h while simultaneously increasing the concentration to 0.9 M.

Following general procedure **C** using 2,2,2-trifluoro-1-(o-tolyl)ethan-1-one (2.16 g, 10.7 mmol) in benzene (12 mL, 889 mM) for 10 h at 22 °C. Analysis by ¹⁹F NMR showed 99% yield of **3d.** The product was obtained after FC (pentane/Et₂O, 75:25) and bulb-to-bulb distillation (110 °C, 0.8 mbar) as a colorless solid (1.59 g, 8.43 mmol, 79%).

### E) Photoisomerization studies

### E1) Reaction set-up

The isomerization process was studied using ¹⁹F NMR. For irradiation experiments, oven dried NMR Tubes with a septum cap were charged with degassed C₆D₆ (0.5 mL, 3x freeze-pump-thaw) in a Glove Box. **1d** was added under inertgas atmosphere *via* a microsyringe through the septum cap and PhCF₃ was added as an internal standard. The tubes were irradiated using a *Luzchem* LZC-ORG photoreactor equipped with 10 8 Watt LZC-UVA mercury lamps **(355 nm)** lamps or a Kessil 45W PR160L **370nm** Gen2 LED at 1 cm distance.

### E2) Kinetic studies

Samples of **1d** (200 mM, 20 mM, 2 mM) were irradiated at 370 nm for selected time intervals at 21 °C. The irradiation time was limited with a timer, that cut the power of the lamp after the selected interval. The progress of the reaction was monitored by ¹⁹F NMR against PhCF₃ as an internal standard. The data is summarized in Table 4and the concentration **[3d]** versus time in seconds is visualized.

**Table 4: Results of the interval irradiation of 1d at various concentrations in degassed C₆D₆ at 22 °C with 370 nm.**

| 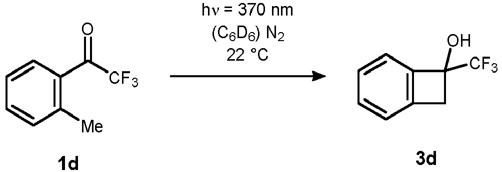 | | | | | |
|---|---|---|---|---|---|
| Entry | time / min | time / s | Yield **3d** / % (200 mM) | Yield **3d** / % (20 mM) | Yield **3d** / % (2 mM) |
| 1 | 0 | 0 | 0 | 0 | 0 |
| 2 | 5 | 300 | 13 | 14 | 17 |
| 3 | 15 | 900 | 36 | 38 | 40 |
| 4 | 30 | 1800 | 60 | 64 | 65 |
| 5 | 45 | 2700 | 75 | 81 | 78 |
| 6 | 60 | 3600 | 85 | 89 | 85 |
| 7 | 90 | 5400 | 94 | 97 | 96 |
| 8 | 120 | 7200 | 98 | >99 | >99 |

### E3) Effect of temperature

Samples of **1d** (20 mM) were irradiated in a water bath equipped with a thermal probe for 30 minutes at 3 cm distance. The data is summarized in Table 5.

**Table 5: Temperature dependent conversion of 1d to 3d (20 mM, C₆D₆) in a water bath with a 370 nm lamp at 3 cm distance.**

| 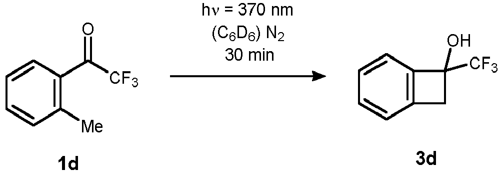 | | | |
|---|---|---|---|
| Entry | *T* / °C | *T* / K | Yield **3d** / % |
| 1 | 20 | 293.15 | 24 |
| 2 | 25 | 298.15 | 35 |
| 3 | 35 | 308.15 | 47 |
| 4 | 45 | 318.15 | 60 |
| 5 | 54 | 327.15 | 69 |

### E4) Use of sun light

Samples of **1d** (20 mM, C₆D₆) were subjected to irradiation in direct sunlight on three different days for 4 h from (12:00h to 16:00h) using a simple reflector setup in Mainz, Germany (49°59'28.3"N 8°13'57.0"E). The NMR tube was secured with a clamp and a reflector was adjusted behind the tube to provide additional reflection of incoming sunlight. The apparatus was checked every hour and adjusted to match the travel of the sun. The data is summarized in Table 6.

**Table 6: Sunlight reaction of 1d (20 mM, C₆D₆) for 4 h.**

| 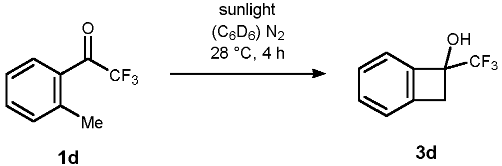 | | | |
|---|---|---|---|
| Entry | T / °C | Weather | Yield **3d** / % |
| 1 | 28 | cloudy | 81 |
| 2 | 28 | clear sky | 95 |

### F) Base screening

Different organic bases were examined for their ability to catalyze back isomerization of **3d** to **1d.**

Samples of **3d** were dissolved in C₆D₆ in an NMR tube and base was added. The tubes were placed in a heated metal block and analyzed by ¹H and ¹⁹F NMR. The results are shown in Table 7:

**Table 7: Base screening for the ring-opening reaction.**

| 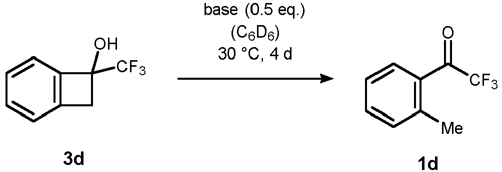 | | | | |
|---|---|---|---|---|
| Entry | *T* / *°*C | *t* / h | Base | Yield **1d** / % |
| 1 | 80 | 96 | NBu₄OH | 0^{a} |
| 2 | 80 | 96 | KO*t*Bu | 49^{a} |
| 3 | 80 | 96 | DBU | 98 |
| 4 | 80 | 96 | - | 0 |
| 5 | 40 | 16 | DBU | 17 |
| 6 | 30 | 16 | DBU | 7 |
| 7 | 30 | 16 | TBD | 98 |
| 8 | 30 | 16 | TBD^{b} | 81 |
| 9 | 30 | 16 | *N*-Me-TBD | 34 |
| 10 | 30 | 44 | *N*-Me-TBD | 75 |
| 11 | 30 | 96 | *N-*Me-TBD | 97 |
| 12 | 30 | 16 | BTPP | 99 |

| | | | | |
|---|---|---|---|---|
| Reactions run on 0.05 mmol scale in C₆D₆ under inert gas atmosphere. Yields determined using ¹H NMR and ¹⁹F NMR with PhCF3 as internal standard. ^{a}HCF₃ detected in ¹⁹F NMR. ^{b}0.2 eq. used. Data not shown Evolution of HCF₃ was evident from ¹H and ¹⁹F NMR with the distinct coupling pattern according to literature. Data not shown | | | | |

### G) Cycle of photoisomerization and base-catalyzed opening

The isomerization process was studied using ¹⁹F NMR. A sample of **1d** (99.6 mg, 492 µmol, 1.00 eq.) was dissolved in benzene (5 mL, 100 mM) in an oven dried Schlenk-flask under inert gas atmosphere and the mixture was degassed (3 × freeze-pump-thaw, liquid nitrogen). The solution was irradiated for 3 h with a 40 W 370 nm Gen 2 KSPR160L Kessil LED from 1 cm distance. PhCF₃ (18.0 mg, 15.0 µL, 123 µmol, 0.25 eq.) was added using a Hamilton syringe as an internal reference. The reaction yield in both transformations, that is photocyclization and opening was found to be unchanged upon addition of PhCF₃ and mesitylene as internal reference compounds for NMR analysis. A sample (0.1 mL) was taken, diluted with C₆D₆ (0.4 mL) and subjected to ¹⁹F NMR analysis. (1,5,7-Triazabicyclo[4.4.0]dec-5-ene on polystyrene support *(Biotage*^{®} PS-TBD, 1.3 mmol/g, 196 mg, 255 µmol, 0.518 eq.) was added to a 10 mL flask and the mixture was transferred along with the sample taken for NMR analysis. The NMR tube was washed with benzene (2 × 0.5 mL), then the flask (3 × 1 mL). The mixture was placed in a heating block and stirred for 24 h at 30 °C. PhCF₃ (18.0 mg, 15.0 µL, 123 µmol, 0.25 eq.) was added, the mixture was stired for 5 minutes, sonicated for 3 minutes and another sample was taken for NMR analysis (0.1 mL diluted with 0.4 mL C₆D₆). The mixture was filtered over a 2 cm thick celite pad with 0.5 cm sand on top, the NMR tube was transferred over the filter and washed (2 × 0.5 mL benzene) and the flask was rinsed (3 × 1mL benzene). Then the filter was washed with portions of benzene (25 mL total), PhCF₃ (18.0 mg, 15.0 µL, 123 µmol, 0.25 eq.) was added and another NMR sample (0.3 mL, diluted with 0.2 mL C₆D₆) was taken. The sample was transferred back (2 × 0.5mL benzene), degassed (3 × freeze-pump-thaw, liquid nitrogen) and irradiated for 3 h with a 40 W 370 nm Gen 2 KSPR160L Kessil LED from 1 cm distance. PhCF₃ (18.0 mg, 15.0 µL, 123 µmol, 0.25 eq.) was added and the final NMR sample was taken (0.3 mL, diluted with 0.2 mL C₆D₆).

A second run was performed using **1d** (101 mg, 498 µmol, 1.00 eq.), PS-TBD (173 mg, 224 µmol, 0.451 eq.) and benzene (5 mL, 100 mM).

The combined data is summarized in Table 8.

**Table 8: Irradiation opening cycle data.**

| 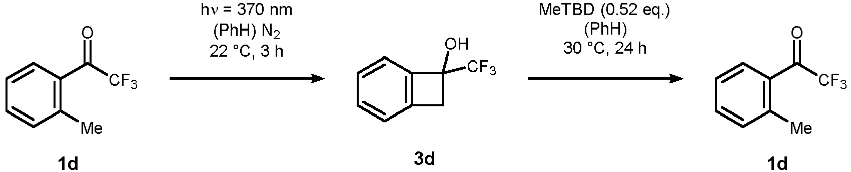 | |
|---|---|
| 1^{st} irradiation | 99.8% ± 0.1% yield^{a} |
| Base opening | 90.1% ± 0.5% yield^{a} |
| Recovery | 98.1% ± 1.3% yield |
| 2^{nd} irradiation | 98.8% ± 0.6% yield³ |

### H) Determination of the thermal isomerization half-life

Samples of solid **3d** (5.64 mg, 30.0 µmol, 1.00 eq.) were added to NMR tubes, that were fused to a closed vial under inert-gas-atmosphere using a propane torch. The tubes were placed in a metal heating block at 220 °C and removed after 1 to 32 hours. The tubes were opened with a glass cutter and rinsed with CDCl₃. PhCF₃ (5 µL, 41µmol, 1.37 eq.) was added as an internal standard and the progress of the thermal isomerization was measured by ¹ H and ¹⁹F NMR. As the MOST system is unimolecular, first order kinetics apply for the modelling of the thermal rate of back conversion. The results are summarized in Table 9:

**Table 9: Summarized data of the thermal heat opening of 3d.**

| Value | 473.15 K | 493.15 K | 513.15 K |
|---|---|---|---|
| *k*₁ (1/s) / s⁻¹ | 5.39 × 10⁻⁶ | 1.91 × 10⁻⁵ | 9.86 × 10⁻⁵ |
| Δ*G*^{≠} / kJ/mol | 165 | 167 | 167 |
| *k*₂ (298.15 K) / s⁻¹ | 1.03 × 10⁻¹⁶ | 4.85 × 10⁻¹⁷ | 5.13 × 10⁻¹⁷ |
| *τ*_{1/2} / years | 2.13 × 10⁸ | 4.53 × 10⁸ | 4.29 10⁸ |

### I) Sensitivity screening

Samples of **1d** were irradiated with a 40 W 370 nm Gen 2 KSPR160L Kessil LED from 2 cm distance in a water bath at 30 °C for 8h.

A stock solution was prepared by dissolving **1d** (27.14 mg, 144 µmol, 1.00 eq.) in C₆D₆ (7 mL, 20 mM) and the solution was degassed (3 × freeze-pump-thaw). PhCF₃ (17.0 µL, 139 µM, 0.96 eq.) was added as an internal reference and the concentration verified via ¹⁹F NMR. Samples were again prepared in a Glove Box. The solution for the big scale was prepared with 1d (37.51 mg, 0.2 mmol, 1.00 eq.) in benzene (10 mL, 20 mM) and the mixture was degassed (3 × freeze-pump-thaw). PhCF₃ (5 µL, 41 µmol, 0.21 eq.) was added with a stir bar. For high and medium concentration (entries 1 & 2, Table 10), oven dried NMR Tubes with a septum cap were charged with degassed C₆D₆ (0.5 mL, 3 × freeze-pump-thaw) in a Glove Box. **1d** was added under inertgas atmosphere *via* a microsyringe through the septum cap and PhCF₃ was added as an internal standard. The samples were subjected to ¹⁹F NMR to verify the concentration before the irradiation. The results are summarized in Table 10 and deviations from the standard reaction conditions are listed. The data is visualized in Fig. 2D.

**Table 10: Evaluation of the robustness of the reaction conditions after 8 h.**

| 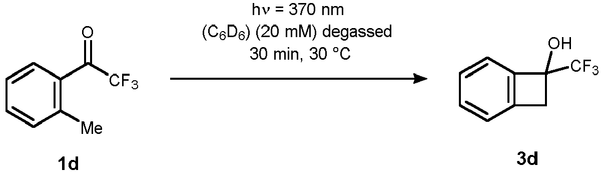 | | | | | | | |
|---|---|---|---|---|---|---|---|
| Entry | | Modification | Procedure | Yield (%) | | Deviation (%) | |
| | 1 | high c | 200 mM | | 96 | | -3 |
| | 2 | medium c | 40 mM | | 95 | | -4 |
| | 3 | low c | 10 mM | | 99 | | 0 |
| | 4 | high H₂O | +5µL H₂O | | >99 | | 1 |
| | 5 | medium O₂ | no degassing | | 79 | | -20 |
| | 6 | high O₂ | purge with O₂ | | 76 | | -22 |
| | 7 | control 1 | | | >99 | | 1 |
| | 8 | high T | 45 °C | | >99 | | 1 |
| | 9 | low T | 20 °C | | 99 | | 0 |
| | 10 | low I | d = 10 cm | | 98 | | -1 |
| | 11 | medium I | *d* = 5 cm | | 99 | | 0 |
| | 12 | big scale | 2 mM scale | | 92 | | -7 |

## Claims

1. A molecular solar thermal system (MOST), comprising a liquid organic phase, which contains
a) in its low-energy ground state primarily at least one solar light excitable low-energy parent isomer (A), which is excitable by solar light in a wavelength range of about300 to 600 nm,
b) in its excited state primarily at least one metastable high-energy photo isomer (B) generated by solar light in a wavelength range of about 300 to 600 nm via photochemical conversion from said at least one solar light excitable low-energy parent isomer (A),
wherein
said at least one metastable high-energy photo isomer (B) is a compound of general formula (I) 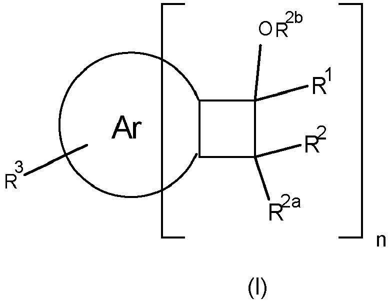 wherein
n is an integer of 1, 2 or 3,
R¹ is selected from -C (halogen)₃₋ₐHₐ, wherein a is 0 or 1, and halogen is selected from F, Cl or Br, in particular-CF₃; aryl; cyano; lower alkoxy, in particular methoxy; or -C(O)OR, wherein R is lower alkyl, in particular methyl; R² and R^{2a} are identical or different and independently of each other selected from H and D; or one of the residues R² and R^{2a} is selected from linear or branched lower alkyl or linear or branched lower alkoxy, like methyl or methoxy, and the other of the residues R² and R^{2a} is selected from H or D; R^{2b} is selected from H or D;
Ar represents an aromatic mono- or polycyclic, in particular mono- or bicyclic, condensed aromatic ring system or conjugated aromatic ring system, in which ring system at least one hydrogen atom of the aromatic ring system may be further substituted by one or more identical or different ring substituents R³,
wherein
R³ is selected from cyano, halogen, linear or branched lower alkyl, in particular methyl; linear or branched lower alkoxy, in particular methoxy; and -C(O)R¹, wherein R¹ is as defined above
or a constitutional isomer or stereoisomer of the compound of formula I;
or a mixture of at least two constitutional isomers or a mixture of at least two stereoisomers or a mixture of at least one constitutional isomer and at least one stereoisomer;
said solar light excitable low-energy parent isomer (A) is a compound excitable by solar light in the wavelength range of 300 to 600 nm and having the general formula (II) 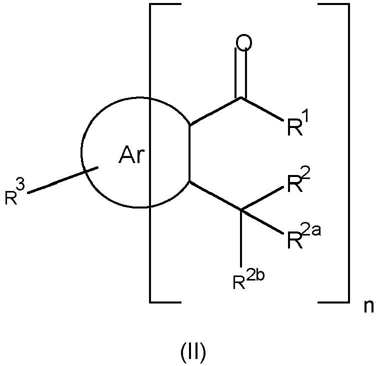 wherein
n, Ar, R¹, R²,R^{2a}, R^{2b}and R³ are as defined above; and
or a constitutional isomer or stereoisomere of the compound of formula II;
or a mixture of at least two constitutional isomers or a mixture of at least two stereoisomers or a mixture of at least one constitutional isomer and at least one stereoisomer;;
and optionally further comprising
an immobilized or non-immobilized form of at least one organic strong base catalyst (C), in particular at least one organic base selected from the group of organic super bases, which organic base catalyzes the thermal re-conversion of the high energy photo isomer (B) via anion-accelerated electro-cyclic ring opening into the corresponding parent isomer (A) by setting free thermal energy as stored by (B).

2. The MOST system of claim 1, wherein said organic superbases are selected from the amidine class, the guanidine class or the phosphazene class.

3. The MOST system of anyone of the preceding claims, wherein the base C is a base comprising
a) a guanidine-type organic superbase of the general formula IIIa or IIIb 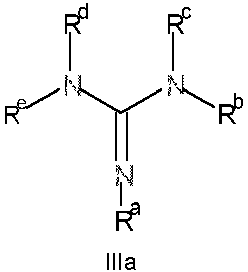 wherein
R^{a} is selected from H, linear or branched lower alkyl, or mono- or polycyclic, aromatic or non-aromatic C₅ to C₁₆ residues, optionally substituted with at least one basic residue comprising at least one basic nitrogen atom,
R^{b} and R^{c} independently of each other represent H, lower alkyl, optionally substituted aryl or heteroaryl, optionally substituted cycloalkyl, optionally substituted hetero-cycloalkyl, and
R^{d} and R^{e} independently of each other represent H, lower alkyl, optionally substituted aryl or heteroaryl, optionally substituted cycloalkyl, optionally substituted hetero-cycloalkyl
or
one residue of R^{b}and R^{c} and one residue of R^{d} and R^{e} together with the nitrogen atoms to which they are attached to, form a heterocyclic, saturated or non-saturated 5 -to 7-membered ring;
or
R^{a} and one of the residues R^{b} and R^{c} or one of the residues R^{d} and R^{e} together with the nitrogen atoms to which they are attached to, form a heterocyclic, saturated or non-saturated 5 -to 7-membered ring;
or of the general formula IIIb 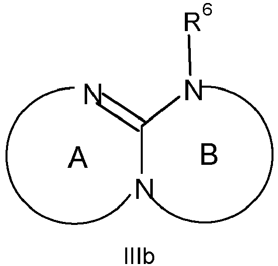 wherein
A and B independently of each other form a 5- to 7-membered heterocyclic saturated or unsaturated ring; and
R⁶ is selected from H or linear or branched lower alkyl,
or
b) an amandine-type organic superbase of the general formula IIIc 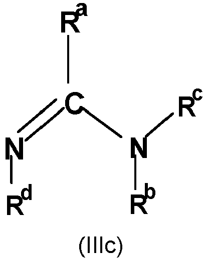 wherein
R^{a}, R^{b}, R^{c} and R^{d} are as defined above;
or
R^{a} and one of the residues R^{b} and R^{c} together with the carbon or nitrogen atoms to which they are attached to, form a heterocyclic, saturated or non-saturated 5 -to 7-membered ring;
and/or
R^{d} and one of the residues R^{b} and R^{c} together with nitrogen atoms to which they are attached to, form a heterocyclic, saturated or non-saturated 5 -to 7-membered ring;
or
c) a phosphazene-type organic superbase of the general formula IIId 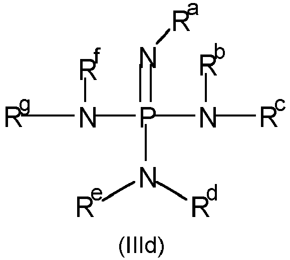 wherein,
R^{a} is as defined above;
R^{b}, R^{c}, R^{d} and R^{e} are as defined above,
R^{f} and R^{g} have the same meanings as defined above for R^{b}, R^{c}, R^{d} and R^{e} and additionally
R^{b} and R^{c} together and/or R^{d} and R^{e} together and/or R^{f} and R^{g} together form a residue of the formula
=P(N-(lower alkyl)₂)₃
or
R^{b}and R^{c} together and/or R^{d} and R^{e} together and/or R^{f} and R^{g} together with the nitrogen atom which they are attached to form a 5- to 7-membered saturated or unsaturated heterocyclic moiety;
or
one residue of R^{b}and R^{c} and one residue of R^{d}and R^{e} together with the nitrogen atoms to which they are attached to, form a heterocyclic, saturated or non-saturated 5 -to 7-membered ring;
or
one residue of R^{b}and R^{c} and one residue of R^{f} and R^{g} together with the nitrogen atoms to which they are attached to, form a heterocyclic, saturated or non-saturated 5 -to 7-membered ring;
or
one residue of R^{d} and R^{e} and one residue of R^{f} and R^{g} together with the nitrogen atoms to which they are attached to, form a heterocyclic, saturated or non-saturated 5 -to 7-membered ring.
or an immobilized derivative of a compound of formula IIIa, IIIb, IIIc or IIId, in particular a derivative of compound of formula IIIa, IIIb, IIIc or IIId covalently bound to an inert carrier bead, particularly microbeads in an average size range of 75-150 µm.

4. The MOST system of claim 3, wherein C is a base comprising a guanidine type superbase selected from a compound of the general formula IV 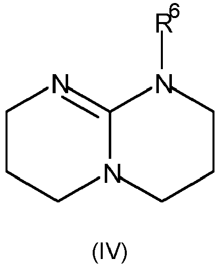 wherein
R⁶ is H or lower alkyl;
or a amidine-type superbase selected from a compound of general formula V 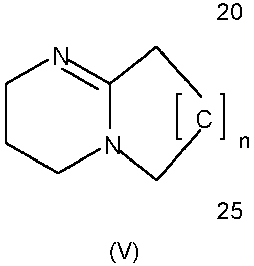 wherein
n is an integer of 1 to 4;
or a phosphazene type superbase of the formula IX 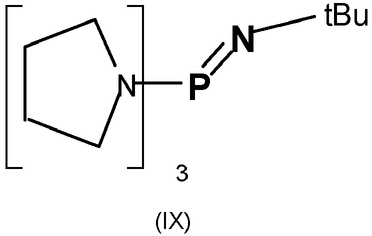 or an immobilized derivative of a compound of formula IV or V, in particular a derivative of compound of formula IV or V covalently bound to inert carrier beads, particularly microbeads of an average size range of 75 - 150 µm.

5. The MOST system of claim 1, wherein isomer (A) is ortho-methyl-trifluoroacetophenone (MTA) of formula VI; 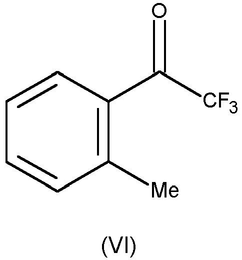 isomer (B) is benzo-trifluoromethylcyclobutanol (BTC) of formula VII: 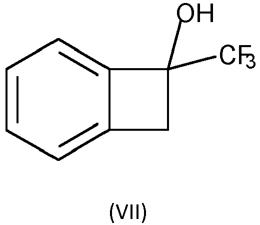 and base C is a guanidine type superbase of of formula VIII 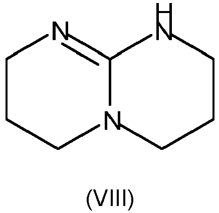 or an immobilized derivative of a compound of formula VIII, in particular a derivative of compound of formula VIII covalently bound toinert carrier bead, particularly microbeads of an average size range of 75 - 150 µm; and particularly, wherein said carrier beads are non-soluble in the liquid phase of the MOST system.

6. The MOST system of anyone of the preceding claims, wherein the liquid phase comprises at least one organic aprotic organic solvent, in particular at least one aromatic solvent, more particularly a solvent selected from benzene, toluene, or cyclic or non-cyclic aliphatic solvents, like in particular xylole und n-heptane, n-hexane or cyclohexane.

7. A method of storing solar thermal energy, which method comprises exposing least one low-energy parent isomer (A) as defined in claim dissolved in a liquid organic medium to solar light for a period of time sufficient to photo isomerize at least one isomer (A) as defined in claim 1 into its corresponding metastable high-energy isomer (B) as defined in claim 1, wherein in particular solar energy is stably stored for at least 1 month, particularly at least 1 year, more particularly more than 5 years.

8. A method of releasing stored solar thermal energy, which method comprises contacting least one metastable high-energy photo isomer (B) as defined in claim 1 dissolved in a liquid organic medium with a base catalyst (C) as defined in claim 1 as defined above catalyzing the terminal back-conversion of the photo isomer (B) into the corresponding parent isomer (A) as defined in claim 1, wherein in particular the stored energy as represented by the energy difference ΔH_{storage} corresponding to the energy difference between isomer (A) and (B) as defined in claim 1 is set free.

9. A method for reversibly storing solar thermal energy, which method comprises applying a MOST system as defined in anyone of the claims 1 to 5.
said method for reversibly storing solar thermal energy comprises
a) exposing at least one low-energy parent isomer (A) as defined in claim 1 dissolved in a liquid organic medium to solar light comprising light of a wavelength in the range of 300 to 600 nm for a period of time sufficient to photo isomerize at least one compound (A) as defined in claim 1 into its metastable high-energy photo isomer (B) as defined in claim 1 in order to obtain a high-energy storage medium;
b) storing said energy-rich medium for a prolonged period of time;
c) contacting said high-energy medium with an immobilized base catalyst (C) as defined in claim 1 catalyzing the terminal back-conversion of the photo isomer (B) into the corresponding parent isomer(A) by setting free thermal energy as stored by (B) in order to obtain a thermally heated medium; and
d) withdrawing thermal energy from said thermally heated medium so as to obtain the initial low-energy medium comprising said at least one low-energy parent isomer (A).

10. A device selected from
a) a solar thermal energy storage device, which comprises at least one metastable high-energy photo isomer (B) as defined in claim 1; in particular a solar thermal energy storage device, comprising a storage vessel T3 containing said medium comprising at least one metastable high-energy photo isomer (B) as defined in claim 1, which storage device further comprises a reactor module R containing immobilized catalyst (C) as defined in claim 1 for the controlled release of stored energy upon getting into contact with the at least one metastable high-energy photo isomer (B).

11. The use of a compound of general formula (I) as defined above and/or of a compound of general formula (II) as defined above for a reversible storing of solar thermal energy.

12. A solar thermal energy capture device (SC), which comprises a transparent top layer permeable for solar light at least in a wavelength range above 300 nm, and a below said transparent top layer ab energy capture compartment (receiving tank T2) optionally provided with a solar light permeable bottom layer, further comprising an inlet for an energy capture medium comprising at least one solar light excitable organic compound (A) of formula (II) as defined in claim 1 and an outlet for an energy capture medium enriched with at least one metastable high-energy photo isomer (B) of formula (I) as defined in claim 1 , which energy capture medium traverses said device in a directed flow from the inlet to the outlet.

13. A combined device for capturing solar thermal energy and solar photoelectric energy, comprising an upper solar thermal capture device SC according to claim 12, and a lower photoelectric compartment for capturing solar photoelectric energy comprising a photoelectric layer; said upper solar thermal capture device comprises an upper layer permeable for solar light and a lower bottom layer permeable for solar light, so that solar light, which enters the upper solar thermal capture device and which is not absorbed by the energy capture medium traversing said upper solar thermal capture device, is absorbed by said photoelectric layer to generate electric energy.

14. A device for operating a MOST system as defined in anyone of the claims 1 to 9, which device comprises:
a) a solar thermal energy capture device SC which comprises a receiving tank T2 comprising a top layer permeable for solar light at least in a wavelength range above 300 nm, an inlet / outlet pair connected by connecting pipes 7a, 7b, 7callowing a circulating flow of a liquid phase in a circle C1, comprising at least one light excitable low-energy parent isomer A of the above general formula II, whereby isomer A is converted to its corresponding metastable high-energy isomer B;
b) a storage tank T3 connected to receiving tank T2 via connecting pipe 9 comprising a first inlet for receiving from tank T2 liquid phase enriched with metastable high-energy isomer B, and an inlet/outlet pair connected by a connecting pipe s 13a, 13b, 13cfor circulating said liquid phase enriched with metastable high-energy isomer B in a circle C2;
c) a reactor R comprising an inlet / outlet pair connected to connecting pipes 20a, 20b, 20c and containing immobilized catalyst C which catalyzes the back conversion of high energy metasabile isomer B to isomer A with release of thermal energy while ; and said liquid medium containing said metastable isomer B circulates in a circle C3;
d) a heat exchanger HE adapted to retrieve thermal energy from reactor R and to transfer the retrieved thermal energy to a heat storage tank or a heat consuming device.;
and in particular
e) a storage tank T1 comprising an inlet / outlet pair, wherein the inlet is connected to storage tank T3 via connecting pipe 26 for transferring liquid medium enriched with low energy isomer A to the storage tank T1; and wherein the outlet is connected via connecting pipe 27 to solar energy capture device SC.

15. A compound selected from
a) a metastable high-energy photo isomer (B) of general formula (I) 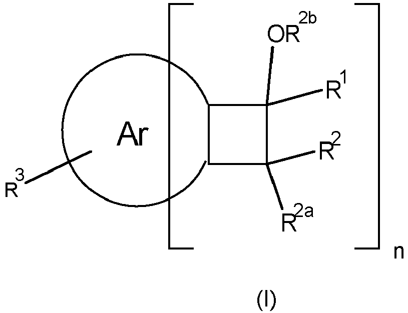 wherein,
n is an integer of 1, 2 or 3,
R¹ is selected from -C (halogen)₃₋ₐHₐ, wherein a is 0 or 1, and halogen is selected from F, Cl or Br, in particular-CF₃; aryl; cyano; lower-alkoxy, in particular methoxy or -C(O)OR, wherein R is lower alkyl, in particular methyl; residues R² and R^{2a} are identical or different and independently of each other selected from H and D; or one of the residues R² and R^{2a} is linear or branched lower alkyl or linear or branched lower-alkoxy, like methyl or methoxy; and the other of the of the residues R² and R^{2a} is H or D;
R^{2b} is selected from H or D;
Ar represents an aromatic mono- or polycyclic, in particular mono- or bicyclic, condensed aromatic ring system or conjugated aromatic ring system, in which ring system at least one hydrogen atom of the aromatic ring system may be further substituted by one or more identical or different ring substituents R³,
wherein
R³ is selected from cyano, halogen, linear or branched lower alkyl, in particular methyl, and linear or branched lower alkoxy, in particular methoxy; and -C(O)R¹, wherein R¹ is as defined above;
or a constitutional isomer or stereoisomer of the compound of formula I;
or a mixture of at least two constitutional isomers or a mixture of at least two stereoisomers or a mixture of at least one constitutional isomer and at least one stereoisomer;
with the proviso that, when Ar is a monocyclic 6-memberd aromatic ring and R³ is missing, then n is an integer of 2 or 3; and
with the proviso that compounds of formula I are excluded; wherein R¹ is CF₃, Ar is a 6-membered aromatic ring wherein R³ is missing, R^{2a} and R^{2b} are H and R² is H or 4-n-butenyl.
or
b) a low-energy compound having the general formula (II) 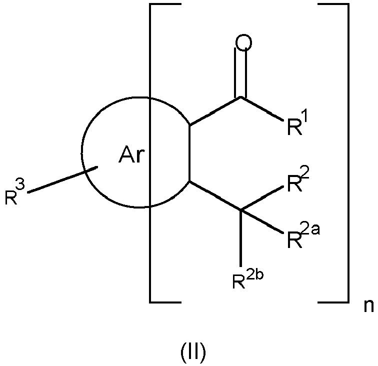 wherein
n, Ar, R¹, R², R^{2a} and R^{2b} and R³ are as defined above in item a)
or a constitutional isomer or stereoisomer of the compound of formula II;
or a mixture of at least two constitutional isomers or a mixture of at least two stereoisomers or a mixture of at least one constitutional isomer and at least one stereoisomer.
